# EUROPEAN PATENT APPLICATION

(11) **EP 2 492 277 A1**
(43) Date of publication of application: **29.08.2012**
(21) Application number: 11156029.8
(22) Date of filing: 25.02.2011
(51) Int. Cl.: C07F 15/06, H01M 14/00

(54) **Improved redox couple for electrochemical and optoelectronic devices**

(71) Applicant: Ecole Polytechnique Fédérale de Lausanne (EPFL), 1015 Lausanne (CH)
(72) Inventor: Nazeeruddin, Md. Khaja, 1024 Ecublens (CH); Graetzel; Michael, 1025 St-Sulpice (CH); Baranoff, Etienne, 1020 Renens (CH); Kessler, Florian, 1004 Lausanne (CH); Yum, Jun-Ho, 1022 Chavannes-Renens (CH)
(74) Representative: Ganguillet, Cyril

(57) **Abstract**

The present invention provides an improved redox couple for electrochemical and optoelectronic devices. The redox couple is based on a complex of a first row transition metal, said complex containing at least one mono-, bi-, or tridentate ligand comprising a substituted or unsubstituted ring or ring system comprising a five-membered N-containing heteroring and/or a six-membered ring comprising at least two heteroatoms, at least one of which being a nitrogen atom, said five- or six-membered heteroring, respectively, comprising at least one double bond. The invention also relates to electrolytes and to the devices containing the complex, and to the use of the complex as a redox couple.

## Description

### Technical Field

The present invention relates to complexes, which are useful in electrochemical and/or optoelectronic devices, electrochemical and optoelectronic devices comprising the complexes, as well as electrolytes comprising the complexes and various uses of the complexes.

### Prior Art and the Problem Underlying the Invention

The dye-sensitized solar cell (DSSC) is attracting wide spread attention as a promising new generation of photovoltaic technology. Mimicking the principle of natural photosynthesis, its ecological and economical fabrication processes make it an attractive and credible alternative to conventional photovoltaic systems (Gratzel, M. Accounts Chem Res 2009, 42, 1788-1798.).

One of the key components of the DSSC is the hole conductor (HC) transporting positive charge carriers from the sensitizer to the back contact of the device. Electrolytes containing the iodide/triiodide redox system are commonly used as HCs due to their high reliability and good power conversion efficiency (PCE) (Wang, Z.-S.; Sayama, K.; Sugihara, H. The Journal of Physical Chemistry B 2005, 109, 22449-22455). However, the I⁻/I₃⁻ redox couple suffers from too low a redox potential resulting in an excessive thermodynamic driving force for the dye regeneration reaction. This limits the open circuit potential of current DSSCs to 0.7 - 0.8 V. Iodide containing electrolytes also corrode a number of metals such as, for example, Ag and Cu, imposing restrictions on the use of such materials as current collectors in DSSC modules. It is noted that iodide and triiodide are very small molecules, which can easily reach the TiO₂ semiconductor surface that is often used in such devices. Contact with the semiconductor surface increases the chances of recombinations with the electrons in the semiconductor, ultimately decreasing the efficiency of the device. Furthermore, triiodide (I₃⁻) absorbs light in competition with the sensitizing dye.

In this context the development of stable non-corrosive redox couples is warranted. A whole variety of alternative mediators have been investigated in the past including halogenides⁵ or pseudohalogenides organic radicals or thiols and inorganic or organic p-type conductors. So far, all these redox mediators exhibited inferior PCEs compared to the I⁻/I₃⁻ couple, especially under full sunlight. This holds also for cobalt polypyridine complexes, reported in WO 03/038508, whose PCE under standard AM 1.5 conditions remained below 5% despite of extensive investigations over the last decade (Nusbaumer, H. et al., M. J Phys Chem B 2001, 105, 10461-10464).

Remarkably, Feldt *et al.* recently increased the PCE to 6.7 % by employing a newly designed D-π-A sensitizer coded D35 in conjunction with cobalt (II/III) trisbipyridyl complex (Feldt, S. et al., J. Am. Chem. Soc. 2010, 132, 16714-16724). However, D35 harvest sunlight only below 620 nm limiting the short circuit photocurrent (J_{SC}) to 10-11 mA/cm².

In view of the above, the present invention addresses the problem of replacing the I⁻/I₃⁻ redox couple in photoelectrochemical conversion devices by a redox-couple exhibiting less corrosiveness to materials that might be of use in the preparation of DSSCs, such as metals and sealing materials, for example.

Furthermore, it is an objective to provide a redox-couple that does not exhibit a high overpotential for dye regeneration. It is an objective to provide a redox couple resulting in a relatively high or increased open current potential (V_{OC}) of the electrochemical device containing the redox couple. It is also an objective of the invention to provide a redox couple with a comparatively high oxidation potential, and/or an adjustable oxidation potential. In particular, it is an objective to provide a redox-couple the oxidation portential of which can be adjusted in dependence of other device parameters, for example to a particular dye, so that efficient charge transfer to the dye can take place, while still improving on V_{OC} of the cell. It is an objective of the invention to provide a less light absorbing redox couple than iodide/triiodide system.

It is also an objective of the invention to provide more stable devices and devices having improved or higher conversion efficiency (PCE), which may be obtained by increasing V_{OC} or in other ways.

It is a further objective of the invention to provide a redox couple the charge of which can be adjusted or varied. For example, in certain situations it is considered advantageous to provide a non-charged or negatively charged redox couple. This may apply to the reduced or to the oxidized state, or to both states.

It is also an objective to provide a less absorbing redox system.

The present invention addresses the problems depicted above, which are part of the invention.

### Summary of the Invention

Remarkably, the invention provides improved redox couples based on complex of first row transition metals containing a ligand comprising a substituted or unsubstituted ring or ring system comprising a five-membered heteroring and/or a six-membered ring comprising at least two heteroatoms. Surprisingly, the five- or six-membered heteroring affects the oxidation portential of the metal complex, thereby providing an effective redox couple with a high oxidation potential. The invention is further based on the finding that it is possible to advantageously adjust the oxidation potential by using suitable ligands and/or by choosing particular substituents or components in the ligand.

Therefore, in a first aspect, the present invention provides a complex comprising a first row transition metal containing a ligand comprising a substituted or unsubstituted ring or ring system comprising a five-membered heteroring and/or a six-membered ring comprising at least two heteroatoms.

In a second aspect, the present invention provides a complex of formula (I) below:

M (La)ₙ (Xb)ₘ (I)

wherein:
M is a 1^{st} row transition metal;
n is an integer from 1 to 6 and a is a consecutive number of a first set consisting of the integers of 1 to n (1, ..., n), so that there are n ligands L1, ... , Ln;
m is 0 or an integer from 1 to 5 and b is a consecutive number of a second set consisting of 0
and integers of 1 to m (0, ..., m), so that if m>0 there are m ligands X1, .. , Xm;
wherein n and m equal the appropriate number of ligands present on metal M;
any La (L1, ... , Ln) is independently selected from a mono-, bi-, or tridentate ligand, with the proviso that at least one of La (L1, ... , Ln) comprises a substituted or unsubstituted ring or ring system comprising a five-membered N-containing heteroring and/or a six-membered ring comprising at least two heteroatoms, at least one of which being a nitrogen atom;
Xb is independently a monodentate co-ligand.

In a third aspect, the present invention provides an electrochemical or optoelectronic device comprising the complex of the invention.

In a fourth aspect, the present invention provides an electrochemical device comprising a first and a second electrode and, between said first and second electrode, an intermediate layer, for example an electrolyte layer, said intermediate layer comprising the complex of the invention.

In a fifth aspect, the present invention provides a method of preparing an electrochemical device, the method comprising the steps of: providing a first and a second electrode, providing an intermediate layer, and adding the complex of the invention to the intermediate layer.

In a sixth aspect the present invention provides the use of the complex of the invention as a redox-couple of an electrochemical device.

In a seventh aspect, the present invention provides the use of ligands and substituents as detailed in this specification for adjusting the oxidation potential of a redox couple and/or of the complex of the invention.

In another aspect, the present invention provides an electrolyte comprising the complex of the invention.

Further aspects and preferred embodiments of the invention are defined herein below and in the appended claims. Further features and advantages of the invention will become apparent to the skilled person from the description of the preferred embodiments given below.

### Brief Description of the Drawings

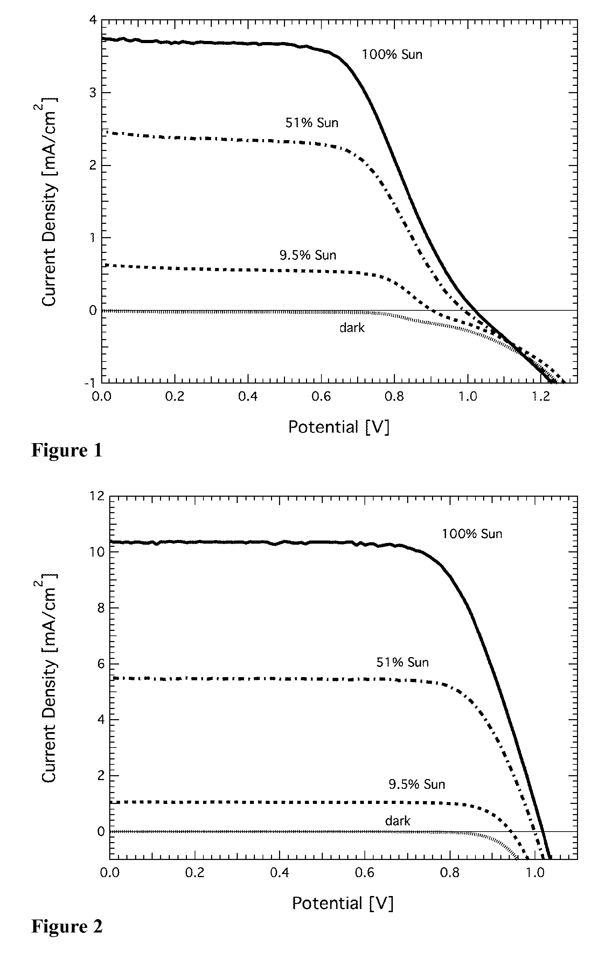

**Figure 1** shows Current (I)-Voltage (V) characteristic of a dye-sensitized solar cell containing the Y123 dye on 2.7 µm TiO₂ with cobalt bidentate redox couples using a bidentate ligand in accordance with an embodiment of the present invention.
**Figure 2** shows Current (I)-Voltage (V) characteristic of a dye-sensitized solar cell containing the Y123 dye on 2.7 µm TiO₂ with cobalt redox couples according to another embodiment of the invention.
**Figure 3** shows Current (I)-Voltage (V) characteristic of dye-sensitized solar cell containing the Y123 dye on 5.5 µm transparent TiO₂ layer + 4 µm scattering layer with cobalt tridentate redox couples according to an embodiment of the invention.
**Figure 4** shows the incident-photon to current conversion efficiency of dye-sensitized solar cell containing the Y123 dye on 5.5 µm transparent TiO₂ layer + 4 µm scattering layer with cobalt tridentate redox couples according to the same embodiment of the invention as Figure 3.
**Figure 5** (Figures 5-1 and 5-2) shows exemplary tridentate ligands La (H-1 to H-31) based on a substituted bipyridine, which ligands may be used in a complex in accordance with an embodiment of the invention.
**Figure 6** (6-1 and 6-2) shows exemplary tridentate ligands La (J-1 to J-26) based on a substituted phenantroline, which ligands may be used in a complex in accordance with an embodiment of the invention.
**Figure 7** (7-1 and 7-2) shows exemplary tridentate ligands La (K-1 to K-33) based on a di-substituted pyridine, which ligands may be used in a complex in accordance with an embodiment of the invention.
**Figure 8** shows exemplary tridentate ligands La (L-1 to L-4) based on a di-substituted pyrazole, imidazole or pyrrole, which ligands may be used in a complex in accordance with an embodiment of the invention.
**Figure 9** (9-1 and 9-2) shows exemplary ligands (M-1 to M-15) of a similar type as those shown in Figure 5, with additional substituents being present.
**Figure 10** (10-1 and 10-2) shows exemplary ligands (N-1 to N-20) of a similar type as those shown in Figure 6, with additional substituents being present.
**Figure 11** (11-1 and 11-2) shows exemplary ligands (P-1 to P- 16) of a similar type as those shown in Figure 7, with additional substituents being present.
**Figure 12** (12-1, 12-2, 12-3, 12-4) shows exemplary bidentate ligands (Q-1 to Q-63) based on substituted pyridine, pyrazole, imidazole or pyrrole, which ligands may be used in a complex in accordance with an embodiment of the invention.
**Figure 13** schematically shows the synthesis of the dye 3-{6-{4-[bis(2',4'-dihexyloxybiphenyl-4-yl)amino-]phenyl}-4,4-dihexyl-cyclopenta-[2,1-b:3,4-b']dithiphene-2-yl}-2-cyanoacrylic acid. The reagents are: (i) 1-bromohexane, K₂CO₃, DMF; (ii) n-BuLi, THF, isopropyl pinacol borate; (iii) 4-bromo-nitrobenzene, Pd(PPh₃)₂Cl₂, Cs₂CO₃, DMF, H₂O; (iv) Zn, NH₄Cl, acetone, H₂O; (v) H₂SO₄, NaNO₂, KI, H₂O; (vi) 6, CuI, 1,10-phenantroline, t-BuOK, toluene; (vii) n-BuLi, THF, isopropyl pinacol borate; (viii) 1, Pd(PPh₃)₂Cl₂, Cs₂CO₃, DMF, H₂O; (ix) cyanoacetic acid, piperidine, CHCl₃.

### Detailed Description of the Preferred Embodiments

The present invention provides novel couples of first row transition metals and their use in electrochemical devices. The complexes contain at least one ligand comprising a substituted or unsubstituted five-membered heteroring and/or a six-membered ring comprising at least two heteroatoms.

The term "comprising", for the purpose of the present specification, is intended to mean "includes, amongst other". It is not intended to mean "consists only of".

According to an embodiment, the complex is a complex of formula (I):

M (La)ₙ (Xb)ₘ (I)

wherein:
M is a 1^{st} row transition metal, for example Cobalt;
n is an integer from 1 to 6 and a is a consecutive number of a first set consisting of the integers of 1 to n (1 , ..., n), so that there are n ligands L1, ... , Ln;
m is 0 or an integer from 1 to 5 and b is a consecutive number of a second set consisting of 0 and integers of 1 to m (0, ..., m), so that if m>0 there are m ligands X1, .. , Xm;
wherein n and m equal the appropriate number of ligands present on metal M;
any La (L1, ... , Ln) is independently selected from a mono-, bi-, or tridentate ligand, with the proviso that at least one of La (L1, ... , Ln) comprises a substituted or unsubstituted ring or ring system comprising a five-membered N-containing heteroring and/or a six-membered ring comprising at least two heteroatoms, at least one of which being a nitrogen atom, said five- or six-membered heteroring, respectively, comprising at least one double bond;
Xb is independently a monodentate co-ligand.

The metal atom M may thus be selected preferably from the metals Sc, Ti, V, Cr, Mn, Fe, Co, Ni, Cu, and Zn. Preferably, M is selected from Fe, Co, Ni, Cu. Most preferably, M is cobalt (Co). As the complex of the invention forms a redox couple, the metal atom M may be present at different oxidation levels in the complex of the invention. For example, the metal atom may be present in the +II and +III oxidative states.

Since n may be an integer from 1 to 6, the complex of formula (I) contain at least one but possibly up to six ligands La. The different embodiments are shown below:
In case n is 1 and L1 is a monodentate ligand, m is 5:
   (II) M L1 X1 X2 X3 X4 X5, wherein X1 to X5 may be the same or different.
In case n is 1 and L1 is a bidentate ligand (m is 4):
   (III) M L1 X1 X2 X3 X4, wherein X1 to X4 may be the same or different.
In case n is 1 and L1 is a tridentate ligand (m is 3):
   (IV) M L1 X1 X2 X3, wherein X1 to X3 may be the same or different.
In case n is 2 and L1 and L2 are both monodentate ligands (m is 4):
   (V) M L1 L2 X1 X2 X3 X4, wherein L1 and L2 may be the same or different, and any one of X1 to X4 may be the same or different.
In case n is 2 and L1 and L2 are both bidentate ligands (m is 2):
   (VI) M L1 L2 X1 X2, wherein L1 and L2 may be the same or different, and X1 and X2 may be the same or different.
In case n is 2, L1 and L2 are a mono- and a bidentate ligands, respectively (m is 3):
   (VII) M L1 L2 X1 X2 X3, wherein L1 and L2 are different any one of X1 to X3 may be the same or different.
In case n is 2 and L1 and L2 are a mono- and a tridentate ligand, respectively (m is 2):
   (VIII) M L1 L2 X1 X2, wherein L1 and L2 are different and any one of X1 and X2 may be the same or different.
In case n is 2, L1 is a bidentate ligand and L2 is a tridentate ligand (m is 1):
   (IX) M L1 L2 X1, wherein L1 and L2 are different.
In case n is 2 and L1 and L2 are both tridentate ligands (m is 0) :
   (X) M L1 L2, wherein wherein L1 and L2 may be the same or different.
In case n is 3 and L1, L2 and L3 are all monodentate ligands (m is 3):
   (XI) M L1 L2 L3 X1 X2 X3, wherein any one of L1 to L3 may be the same or different and any one of X1 to X3 may be the same or different.
In case n is 3 and L1, L2 and L3 are all bidentate ligands (m is 0):
   (XII) M L1 L2 L3, wherein any one of L1, L2 and L3 may be, independently, the same or different from any other of L1, L2, L3, respectively. For example, L1 to L3 may all be the same.
In case n is 3, L1 is a bidentate ligand and, L2 and L3 are both monodentate ligands (m is 2):
   (XIII) M L1 L2 L3 X1 X2, wherein L1 is different from L2 and L3, L2 and L3 may be the same or different, X1 and X2 may be the same or different.
In case n is 3, L1 is a tridentate ligand, L2 and L3 are both monodentate ligands (m is 1):
   (XIV) M L1 L2 L3 X1, wherein L1 is different from L2; L3 and L2 may be the same or different.
In case n is 3, L1 is a tridentate ligand, L2 is a bidentate ligand and L3 is a monodentate ligand (m is 0):
   (XV) M L1 L2 L3, wherein L1, L2 and L3 are all different.
In case n is 4, L1 is a bidentate ligand, L2 to L4 are monodentate ligands (m is 1):
   (XVI) M L1 L2 L3 L4 X1, wherein L1 is different from L2 to L4; and any one of L2 to L4 may be the same or different.
In case n is 4, L1 is a tridentate ligand, L2 to L4 are monodentate ligands (m is 0):
   (XVII) M L1 L2 L3 L4, wherein L1 is different from L2 to L4; and any one of L2 to L4 may be the same or different.
In case n is 4 and L1 to L4 are all monodentate ligands (m is 2):
   (XVIII) M L1 L2 L3 L4 X1 X2, wherein any one of L1 to L4 may be the same or different and X1 and X2 may be the same or different.
In case n is 5, L1 is a bidentate ligand and L2 to L5 are all monodentate ligands (m is 0):
   (XIX) M L1 L2 L3 L4 L5, wherein L1 is differen from L2 to L5 but L2 to L5 may be the same or different.

In the other cases where n is 5 (or 6), m is 1 (or 0, respectively), L1 to L5 (or L1 to L6, respectively), are all monodentate ligands, which may be the same or different.

From the above it becomes apparent that the complexes of the invention may be homoleptic (contain identical ligands La with m being 0) or heteroleptic (containing at least two different ligands).

Preferably, n is 1, 2 or 3, more preferably 2 or 3. If n is 2, L1 and L2 are preferably identical. If n is 3, L1 to L3 are preferably identical.

According to an embodiment of the complex of the invention, n is 2 (M L1 L2) or 3 (M L1, L2, L3) and m is 0 in both cases.

According to an embodiment, the complex of the invention comprises at least 2 or at least 3 ligands La of identical structure (L1=L2 or L1=L2=L3, respectively).

According to an embodiment, the complex of the invention is overall neutral, or carries an overall positive or negative charge. As can be seen from the ligands of the invention as detailed elsewhere in this specification, the charge of the entire complex can be adjusted to be neutral or even negatively charged, in the oxidized or reduced state, as desired, by selecting appropriate negatively charged ligands. For the purpose of the present specification it is considered to be advantageous to be capable of adjusting the charge of the complex, in order to adjust said charge in dependency of other constituents of the electrochemical device of the invention. In particular, the charge of the redox couple can be adjusted to be neutral or negatively charged, so as to avoid electrostatic interactions with other constituents of the device, such as the dye, for example.

Herein below, preferred embodiments of the at least one ligand of the invention are given, said ligand comprising a substituted or unsubstituted ring or ring system comprising a five-membered heteroring and/or a six-membered ring comprising at least two heteroatoms. These embodiments also apply for the ligands La (L1, ... Ln) of the complex of formula (I).

The five- or six membered heteroring may be, independently provided as an unsubstituted or substituted heteroring. The heteroring may be fused to another ring or ring system, and/or two substituents of/on a carbon of the heteroring may form a ring, which may result in a spiro compound in which one of the rings is said five-or six membered heteroring. Furthermore, the five- or six membered heteroring may be connected by a covalent bond to another ring or ring system, for example to a pyridine ring or to a polycyclic system containing one pyridine or more ring.

Preferably, substituted or unsubstituted five- or six membered heteroring (the six membered heteroring comprising at least two heteroatoms), comprises at least one double bond. More preferably, the five- or six membered heteroring is aromatic.

According to a preferred embodiment, the complex of the invention comprises at least one, more preferably at least two, even more preferably at least three bidentate ligands La, which may be the same or different.

According to another, still more preferred embodiment, the complex of the invention comprises at least one, preferably at least two tridentate ligands La, which may be the same or different.

According to an embodiment, at least one of said n ligands La (L1, ... , Ln) comprises a pyridine ring or a ring system comprising a pyridine ring connected by a covalent bond or fused to said five-membered heteroring and/or to said six-membered ring comprising at least two heteroatoms, wherein said pyridine ring or a ring system comprising a pyridine ring may or may not be further substituted.

According to an embodiment, said five- or six membered ring comprises at least on heteroatom selected from the group ofN, O, P and S, preferably at least one N.

According to an embodiment, said five-membered heteroring comprises two or more (preferably up to 4) heteroatoms, and said six-membered heteroring comprises two or more (preferably up to 4) heteroatoms. Preferably, at least a first heteroatom is nitrogen, and at least a second heteroatom or further heteroatom is/are selected, independently, from N, O, P and S. Preferably, said second heteroatom is N, and, if applicable, further heteroatoms (the third, fourth, etc.) are selected independently, from N, O, P and S, preferably they are N.

According to an embodiment, at least one ligand of the complex of the invention is, independently, selected from compounds of formulae (1)-(63) below. Preferably any one of said n ligands La (L1, ... , Ln) of the complex of formula (I), or of any one of the complexes of formula (II) to (XVII), in as far as applicable, is, independently, selected from compounds of formulae (1)-(63) below: 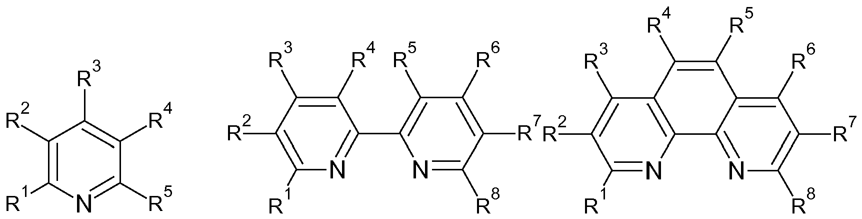 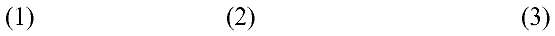 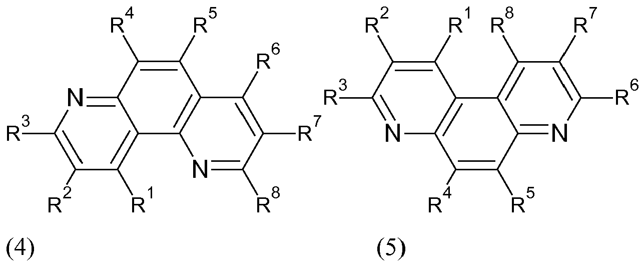 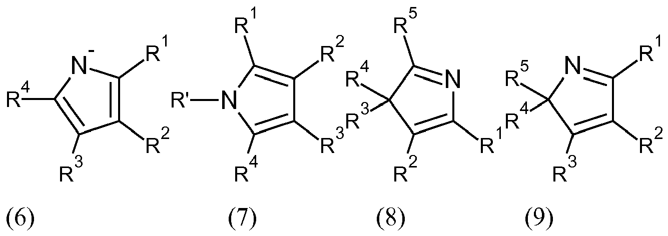 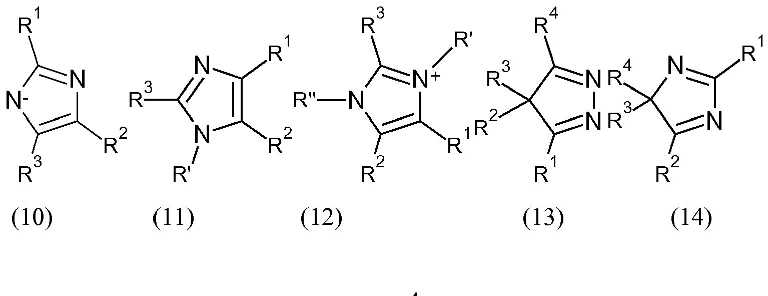 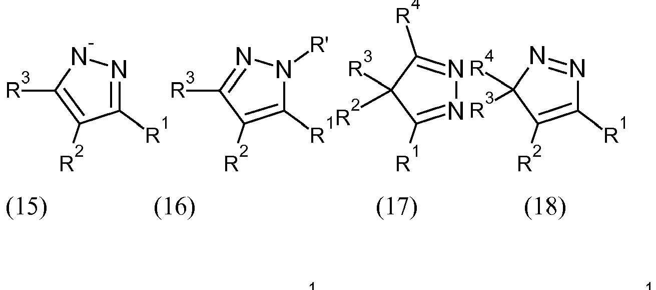 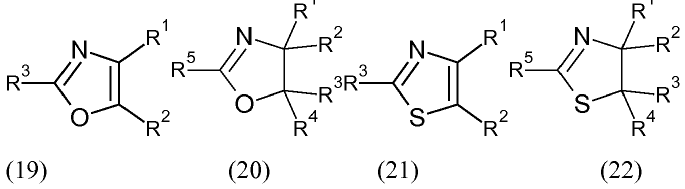 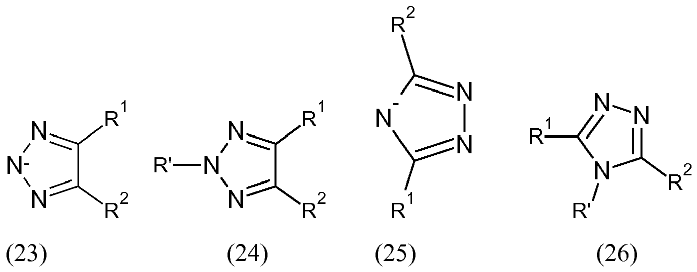 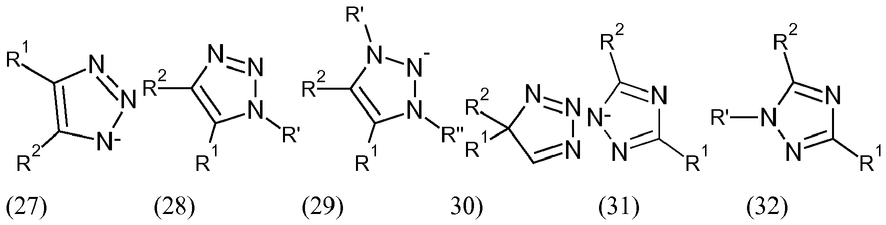 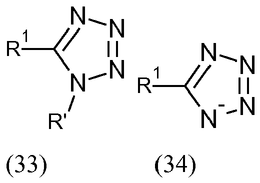 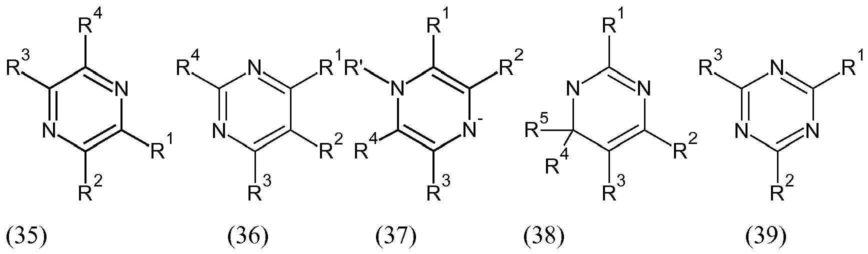 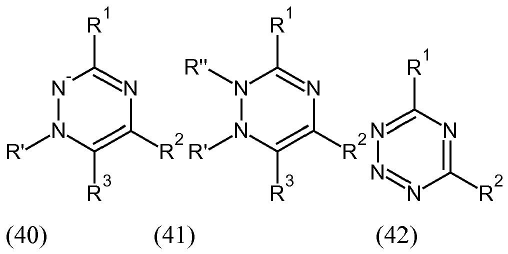 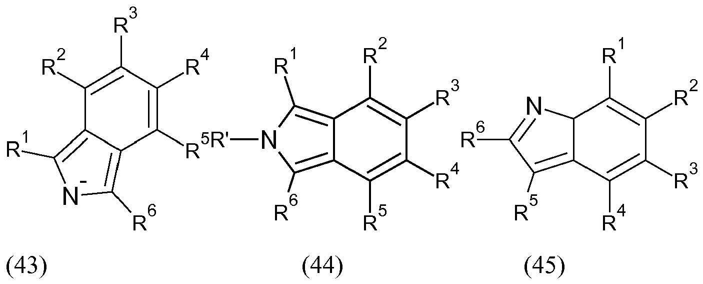 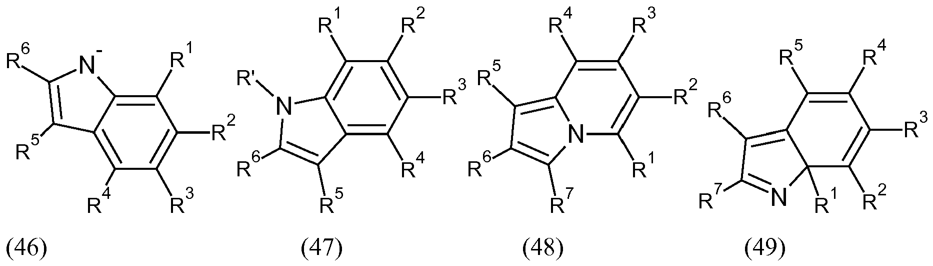 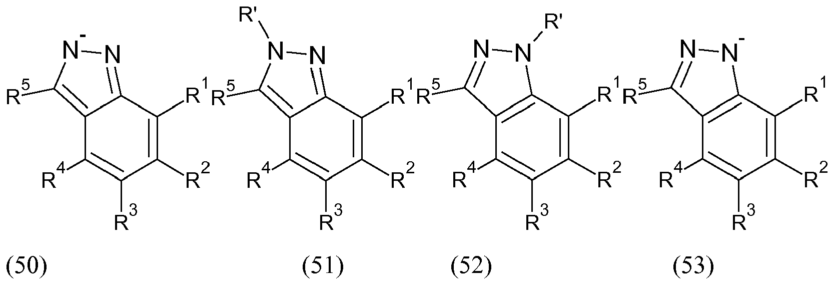 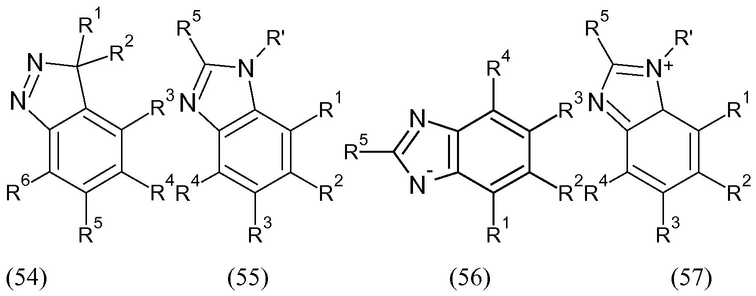 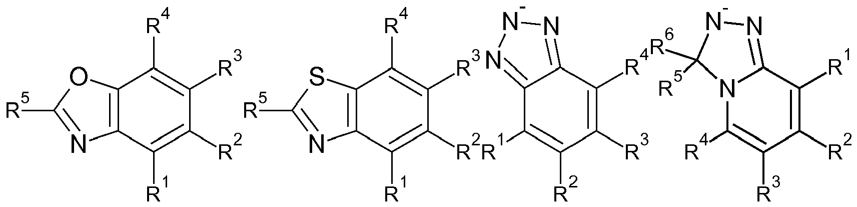 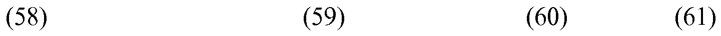 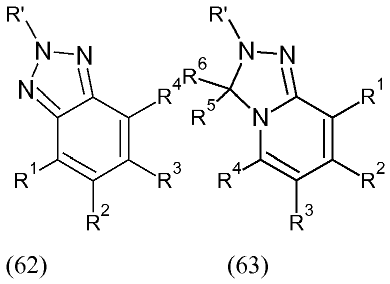 wherein:
any one of R¹, R², R³, R⁴, R⁵, R⁶, R⁷, R⁸, if applicable, may be selected, independently, from H and from hydrocarbons comprising 1 to 50 carbons and 0 to 20 heteroatoms;
R' and R" are selected, independently from substituents -CH₂R¹, -CHR¹R² and- CR¹R²R³; with the proviso that, if the compound is a compound according to any one of formulae (1) to (5) above, at least one of said substituents R¹, R², R³, R⁴, R⁵, R⁶, R⁷, R⁸, in as far as present, is selected, independently, from a substituent of formula (A-1) to (G-2) below: 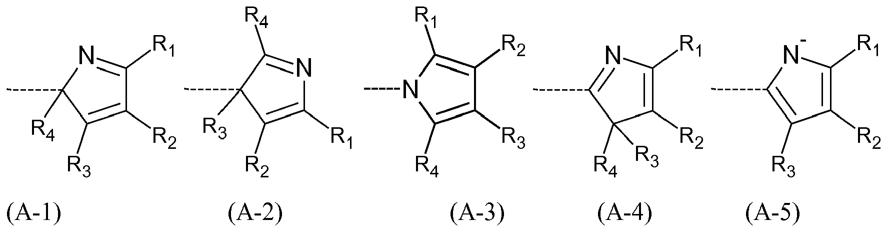 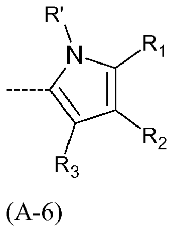 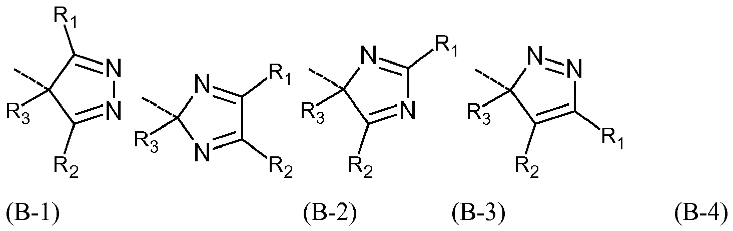 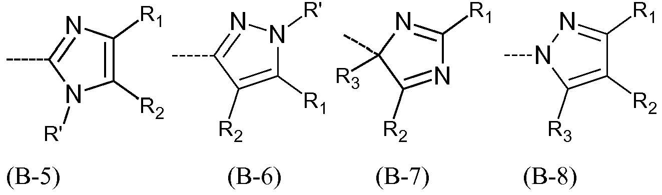 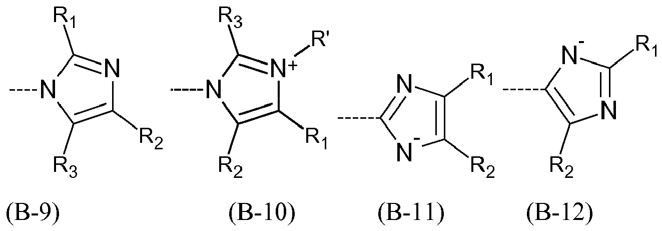 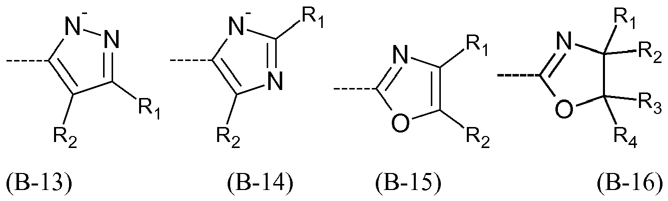 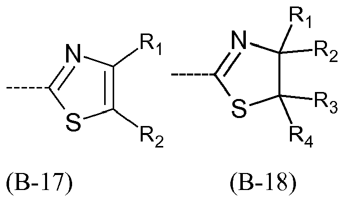 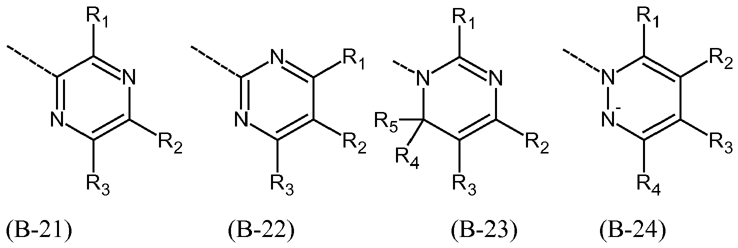 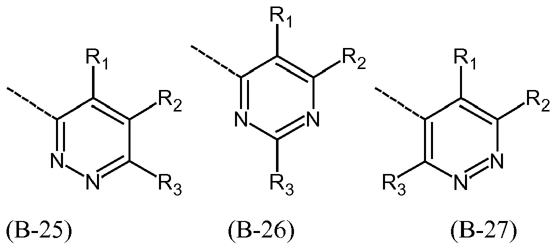 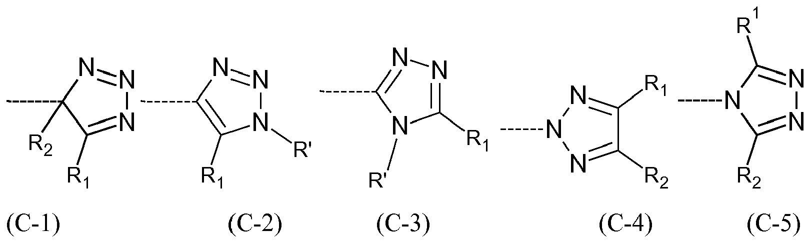 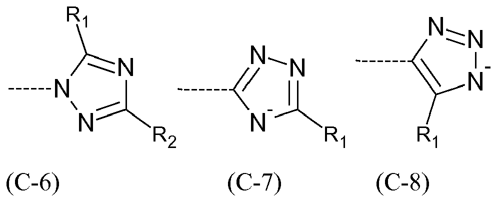 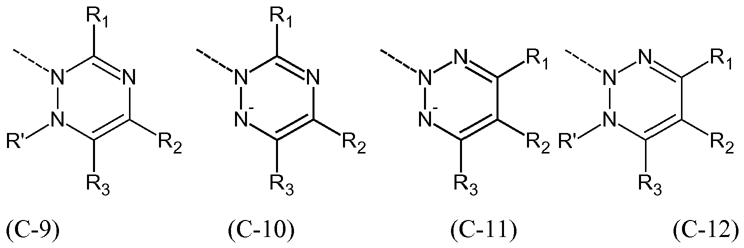 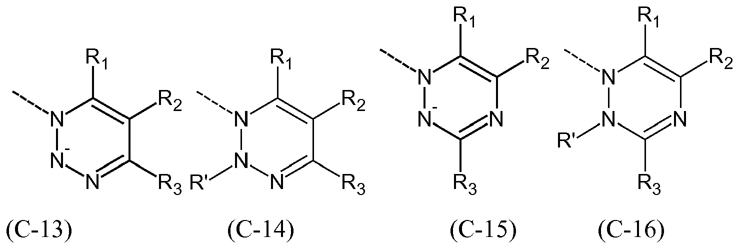 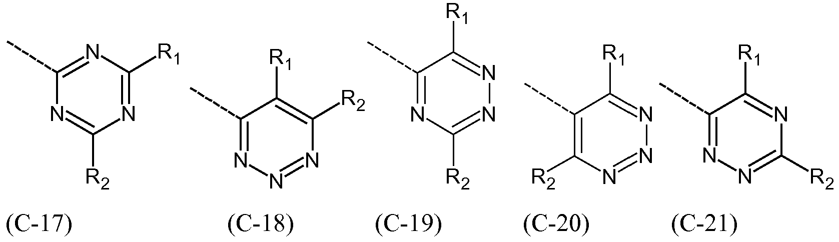 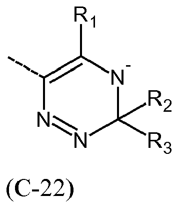 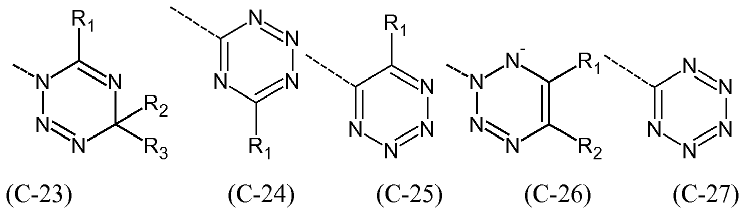 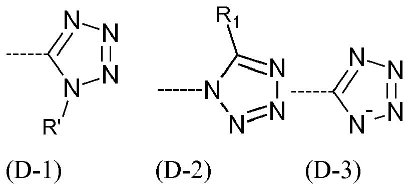 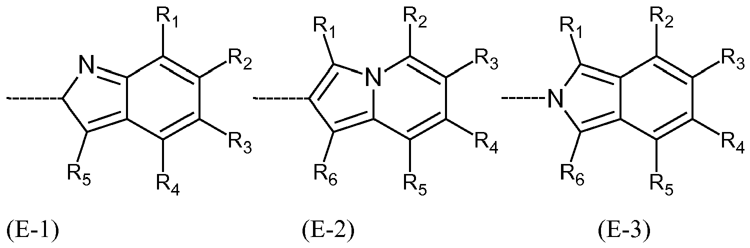 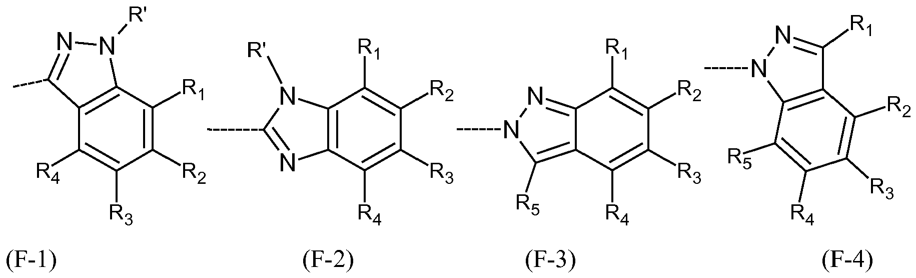 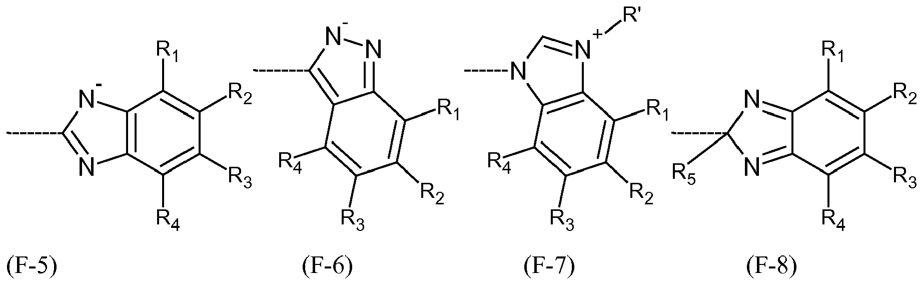 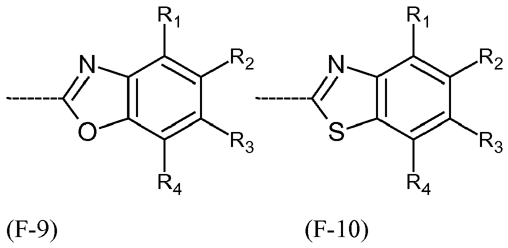 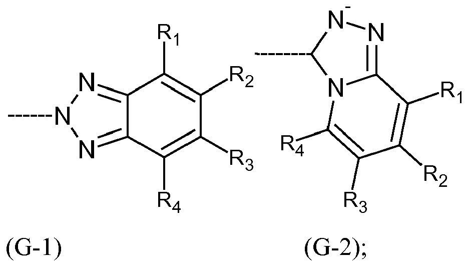 wherein the dotted line represents the bond connecting the substituent of (A-1) to (G-2) on the compound of formula (1)-(63); and, substituents R₁, R₂, R₃, R₄, R₅, R₆, and R₇, in as far as present, are independently selected from H and from hydrocarbons comprising 1 to 50 carbons and 0 to 20 heteroatoms. R' and R" are as defined above and elsewhere in this specification.

Compounds (6) to (63) can be provided in the form of monodentate ligands, whereas compounds (1) to (5), which mandatorily contain at least one substituent according to formulae (A-1) to (G-2), are generally bi- or tridentate ligands. Depending on the choice of the substituents R¹ to R⁸ (in as far as applicable), compounds (6) to (63) may also be provided in the form of bi- or tridentate ligands La (L1, ... , Ln).

Any one of R¹, R², R³, R⁴, R⁵, R⁶, R⁷, R⁸, and of R₁, R₂, R₃, R₄, R₅, _{R}6, and R₇, in as far as the respective substituent is present on the compounds (1) to (63) and their substituents, may thus be independently selected from H and from hydrocarbons comprising 1 to 50 carbons and 0 to 20 heteroatoms, under the proviso mentioned elsewhere in this specification.

Heteroatoms are preferably selected, independently, from Si, N, P, As, O, S, Se halogen (in particular F, Cl, Br and I), B, Be; more preferably from Si, N, P, O, S, and halogen, most preferably from N, O, S and halogen.

According to an embodiment, any one of said substituents R¹, R², R³, R⁴, R⁵, R⁶, R⁷, R⁸, and of R₁, R₂, R₃, R₄, R₅, R₆, and R₇ may be independently selected from H, halogen, -F, -Cl, - Br, -I, -NO₂, -CN, -OH, -CF₃, substituted or unsubstituted C1-C50 alkyl, C2-C50 alkenyl, C2-C50 alkynyl, and C5 to C50 aryl; wherein, in said substituted or unsubstituted alkyl, alkenyl, alkynyl or aryl, any hydrocarbon group (preferably and if applicable: non adjacent hydrocarbon group) may be replaced by any one selected from the group of -O-, -S-, -S(=O)- ,-S(=O)₂-, -Si-, -Ge-, -NR^{A}-, -N=, -BR^{A}-, -PR^{A}-, -P(=O)R^{A}-, -P(=O)OR^{A}-, -C(=O)-, -C(=S)- ,-C(=O)O-, -OC(=O)-, -C(=NR^{A})-, -C=NR^{A}-, -NR^{A}C(=O)-, -C(=O)NR^{A}-, -NR^{A}C(=S)- and -C(=S)NR^{A}-;
wherein, if said alkyl, alkenyl, alkynyl and aryl are substituted, the substituents, and said R^{A}, if present, may, independently, be selected from halogen, -F, -Cl, -Br, -I, -NO₂, -CN, -OH, - CF₃, substituted or unsubstituted C1-C15 alkyl, C2-C15 alkenyl, C2-C15 alkynyl C2-C15 alkynyl, C5 to C18 aryl, wherein any hydrocarbon group of said substituent may be replaced by any one selected from the group of -O-, -S-, -S(=O)-, -S(=O)₂-, -Si-, -Ge-, -NR^{A}-, -N=, - BR^{B}-, -PR^{B}-, -P(=O)R^{B}-, -P(=O)OR^{B}-, -C(=O)-, -C(=S)-, -C(=O)O-, -OC(=O)-, -C(=NR^{B})-, -C=NR^{B}-, -NR^{B}C(=O)-, -C(=O)NR^{B}-, -NR^{B}C(=S)- and -C(=S)NR^{B}-, wherein R^{A} may also be H;
wherein, if said alkyl, alkenyl, alkynyl or aryl substituent is further substituted, the substituents of said substituents, and said R^{B}, if present, may be selected from halogen, -F, - Cl, -Br, -I, -NO₂, -CN, -OH, -CF₃, substituted or unsubstituted C1-C8 alkyl, C2-C8 alkenyl, C2-C8 alkynyl, C5 to C8 aryl, wherein any hydrocarbon group of said substituent may be replaced by any one selected from the group of -O-, -S-, -S(=O)-, -S(=O)₂-, -Si-, -Ge-, -N=, - C(=O)-, -C(=S)-, -C(=O)O-, -OC(=O)-, wherein R^{B} may also be H. Further substituents of said further substituents are preferably selected from halogen, -CN and C1 to C4 alkyl, C2-C4 alkenyl and C2-C4 alkynyl, wherein any available hydrogen of said alkyl, alkenyl or alkynyl may be substituted by halogen.

For the purpose of the present specification, any alkyl, alkenyl or alkynyl specified herein may be linear, branched and/or cyclic. In this case, the alkyl, alkenyl and alkynyl has three or more carbons.

According to a preferred embodiment, any one of R¹, R², R³, R⁴, R⁵, R⁶, R⁷, and R⁸, in as far as present on the compounds (1) to (63), may independently be selected from H and from hydrocarbons comprising 1 to 20 carbons and 0 to 10 heteroatoms; preferably from H and C 1 to C10 hydrocarbons comprising 0 to 10 heteroaotms; more preferably from H and C 1 to C5 hydrocarbons comprising 0 to 5 heteroatoms, under the proviso mentioned elsewhere in this specification.

According to a preferred embodiment, any one of R₁, R₂, R₃, R₄, R₅, R₆, and R₇, in as far as present on the substituents (A-1) to (G-2) above, may be independently selected from H and from hydrocarbons comprising 1 to 20 carbons and 0 to 10 heteroatoms; preferably from H and C1 to C10 hydrocarbons comprising 0 to 10 heteroaotms; more from preferably H and C1 to C5 hydrocarbons comprising 0 to 5 heteroatoms, under the proviso mentioned elsewhere in this specification.

According to an embodiment, any one of R¹, R², R³, R⁴, R⁵ R⁶, R⁷, R⁸, R₁, R₂, R₃, R₄, R₅, R₆, R' and R", if applicable, is selected independently from H, and from C1-C10 alkyls, C2-C10 alkenyls C2-C10 alkynyls, and C5-C12 aryls (preferably C6-C12 aryls), wherein in said alkyls, alkenyls, alkynyls and aryls one, several or all available hydrogen may be replaced by halogen and/or by -CN, wherein any one of said R¹ to R⁸ and R₁ to R₆ may further be selected from halogen and from -C≡N (-CN). Said aryl may or may not be further substituted by C1-C4 alkyl, halogen and-CN.

According to an embodiment, any one of R¹, R², R³, R⁴, R⁵ R⁶, R⁷, R⁸, R₁, R₂, R₃, R₄, R₅, R₆, R' and R", in as far as present, is selected independently from H, and from C1-C6 alkyls, C2-C6 alkenyls C2-C6 alkynyls, and C6-C10 aryls, wherein in said alkyls, alkenyls, alkynyls and aryls one, several or all available hydrogen may be replaced by halogen and/or -CN, wherein any one of said R¹ to R⁸ and R₁ to R₆ may further be selected from halogen and from -C≡N (-CN). Said aryl may or may not be further substituted by C1-C4 alkyl, halogen and -CN.

According to an embodiment, any one of R¹, R², R³, R⁴, R⁵, R⁶, R⁷, R⁸, R₁, R₂, R₃, R₄, R₅, R₆, R' and R", in as far as present, is selected independently, from H, and from C1-C6, preferably C1-C4, more preferably C1-C3 alkyl, said alkyl, being optionally partially or totally substituted by halogen, wherein any one of said R¹ to R⁸ and R₁ to R₆ may further be selected from halogen and from -C≡N.

According to an embodiment, any one of R¹, R², R³, R⁴, R⁵, R⁶, R⁷, R⁸, R₁, R₂, R₃, R₄, R₅, R₆, in as far as present, is selected, independently, from H, halogen, -CN, and from C1-C6, preferably C1-C4 and most preferably C1-C3 alkyl, said alkyl being possibly substituted by halogen.

According to an embodiment, R' and R" are selected independently from H and from C1-C6 linear branched or cyclic alkyl, said alkyl being possibly and optionally partially or totally substituted by halogen.

According to an embodiment, R¹, R², R³, R⁴, R⁵, R⁶, R⁷, R⁸ (with the proviso related to compounds (1) to (5) specified elsewhere in this specification), in as far as present, are selected independently from H, halogen, -CN, and from C1-C6 alkyl and alkenyl, said alkyl and alkenyl, wherein any available hydrogen of said alkyl and alkenyl may or may not be replaced by halogen and/or -CN. Preferably, R¹, R², R³, R⁴, R⁵, R⁶, R⁷, R⁸ (with the proviso related to compounds (1) to (5) specified elsewhere in this specification), in as far as present, are selected independently from H, halogen, -CN, and from C1-C4 alkyl, said alkyl being optionally totally or partially halogenated. Preferably, R¹, R², R³, R⁴, R⁵ R⁶, R⁷, R⁸, in as far as present, are selected independently from H, halogen, -CN, -CF3 and C1-C3 alkyl.

According to an embodiment, R₁, R₂, R₃, R₄, R₅, R₆, in as far as present, are selected independently from H, halogen, -CN, and from C1-C6 alkyl and alkenyl, wherein any available hydrogen of said alkyl and alkenyl may or may not be replaced by halogen and/or - CN. Preferably, R₁, R₂, R₃, R₄, R₅, R₆, in as far as present, are selected independently from H, halogen, -CN, and from C1-C4 alkyl, said alkyl being optionally totally or partially halogenated. Preferably, R₁, R₂, R₃, R₄, R₅, R₆, in as far as present, are selected independently from H, halogen, -CN, -CF₃ and C1-C4 alkyl.

Substituents R¹, R², R³, R⁴, R⁵, R⁶, R⁷, R⁸, R₁, R₂, R₃, R₄, R₅, R₆, other than H are suitable to adjust the oxidation potential of the metal complex. Without wishing to be bound by theory, it is believed that such substituents can help obtaining electrochemical devices with higher V_{oc} values, and to adjust the oxidation potential of the redox couple to the properties of the dye.

According to an embodiment of the complex of the invention, at least one of said ligands La (L1, ... , Ln) is, independently, selected from compounds of formulae (1-2) to (3-2) below: 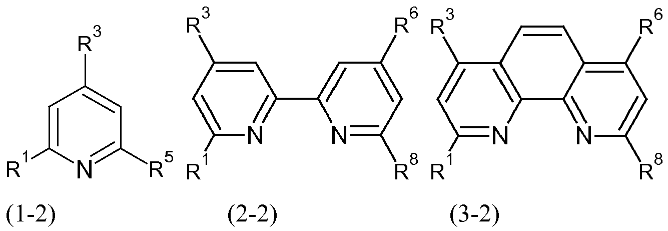 wherein at least one substituent of said compound, selected from substituents R¹, R³, R⁵, R⁶, and R⁸, in as far as present, is selected from the substituents (A-1) to (G-2) as defined elsewhere in this specification.

According to an embodiment, of the complex of the invention, at least one of said ligands La (L1, ... , Ln) is, independently, selected from compounds of formulae (1-3) to (3-3) below: 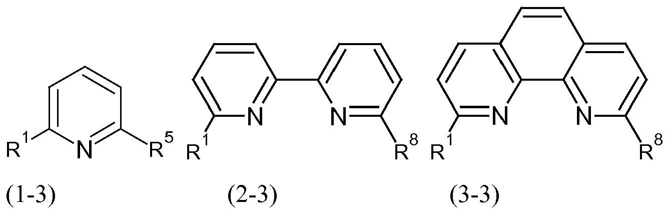 wherein at least one substituent of said compound, selected from substituents R¹, R⁵, and R⁸, in as far as present, is selected from the substituents (A-1) to (G-2) as defined elsewhere in this specification.

The complex of any one of the preceding claims, wherein at least one ligand La is selected from the compounds of formula (1-5) to (3-5) below: 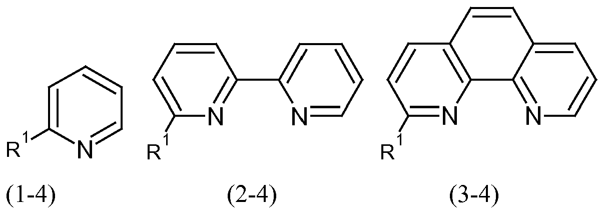 wherein:
R¹ is selected from the substituents (A-1) to (G-2) as specified elsewhere in this specification.

In accordance with the present invention, it was surprisingly found that the presence of a second heteroatom in the ring binding to the metal atom of the complex of the invention is suitable to positively affect the properties and suitability of the complex of the invention as a redox couple.

Therefore, ligands (e.g. La) comprising a ring with at least two ring heteroatoms are particularly preferred. According to this embodiment ("embodiment A"), the complex of the present invention comprises one or more ligands selected from: (10)-(42), (50)-(63), and, more preferably, from complexes comprising the ligands (1), (2), (3), (4), (1-2), (2-2), (3-2), (1-3), (2-3), (3-3), (1-4), (2-4), (3-4), in as far as these compounds comprise at least one substituent selected from: (B-1) to (B-24), (C-17) to (C-27), (D-1) to (D-3), (F-1) to (F-10), (G-1) and (G-2).

According to another embodiment ("embodiment A"'), ligands (e.g. La) comprising a ring with exactly two ring heteroatoms are particularly preferred.

According to an embodiment ("embodiment B"), ligands (e.g. La) comprising at least two adjacent ring heteroatoms are particularly preferred. Accordingly, the complex of the present invention comprises one or more ligands selected from: (13), (15), (16), (17), (18), (23) to (34), (40) to (42), (50) to (54), (60) to (63), and, more preferably, from complexes comprising the ligands (1), (2), (3), (4), (1-2), (2-2), (3-2), (1-3), (2-3), (3-3), (1-4), (2-4), (3-4), in as far as these compounds comprise at least one substituent selected from (B-1), (B-3), (B-6), (B-8), (B-13), (B-24), (B-25), (B-27), (C-1) to (C-8), (C9) to (C-16), (C-18) to (C-27), (D-1) to D-3), (F-1), F-3), (F-4), (F-6), (G-1), (G-2).

According to an embodiment ("embodiment C"), ligands (e.g. La) comprising a five-membered heteroring are particularly preferred. Accordingly, the complex of the present invention comprises one or more ligands selected from: (6) to (34), (43) to (63), and, more preferably, from complexes comprising the ligands (1), (2), (3), (4), (1-2), (2-2), (3-2), (1-3), (2-3), (3-3), (1-4), (2-4), (3-4), in as far as these compounds comprise at least one substituent selected from (A-1) to (A-6), (B-1) to (B-18), (C-1) to (C-8), (D-1) to (D-3), (E-1) to (E-3), (F-1) to (F-10), (G-1) and (G-2).

According to an embodiment ("embodiment D"), ligands (e.g. La) comprising a five-membered heteroring that is not fused to any further ring are particularly preferred. Accordingly, the complex of the present invention comprises one or more ligands selected from: (6) to (34), and, more preferably, from complexes comprising the ligands (1), (2), (3), (4), (1-2), (2-2), (3-2), (1-3), (2-3), (3-3), (1-4), (2-4), (3-4), in as far as these compounds comprise at least one substituent selected from (A-1) to (A-6), (B-1) to (B-18), (C-1) to (C-8), (D-1) and to (D-3).

According to an embodiment ("embodiment E"), ligands (e.g. La) comprising a five- or six-membered heteroring having aromatic properties (being aromatic) are particularly preferred. Accordingly, the complex of the present invention comprises one or more ligands selected from: (6), (7), (10) to (12), (15), (16), (19), (21), (23) to (28), (31) to (34), (35) to (36), (39), (42), (43) to (48), (50) to (53), (55) to (56), (58) to (60) and (62), and, more preferably, from complexes comprising the ligands (1), (2), (3), (4), (1-2), (2-2), (3-2), (1-3), (2-3), (3-3), (1-4), (2-4), (3-4), in as far as these compounds comprise at least one substituent selected from: (A-3) to (G-2).

According to an embodiment ("embodiment F"), the invention provides complexes comprising one or more bi- or tridentate ligands (e.g. La) containing at least one pyridine ring and at least one substituent, wherein said substituent is bound by way of a carbon-nitrogen bond to said pyridine ring. Accordingly, the present invention provides complexes comprising one or more ligands of formula (1), (2), (3), (4), (1-2), (2-2), (3-2), (1-3), (2-3), (3-3), (1-4), (2-4), and/or (3-4), wherein said ligands contain one or more substituents selected from: (A-3), (B-8) to (B-10), (B-23), (B-24), (C-4) to (C-6), (C-9) to (C-16), (C-23), (C-26), (D-2), (E-3), (F-3), (F-4), (F-7), (G-1).

According to an embodiment ("embodiment G"), the complex of the invention comprises one or more bi- or tridentate ligands (e.g. La) comprising at least one pyridine ring and at least one substituent selected from substituents (A-1) to (A-6), (B-1) to (B-27), (C-1) to (C-27), (D-1) to (D-3), (E-1) to (E-3), (F-1) to (F-19) and (G-1) to (G-2).

The above embodiments A to G may be combined with each in as far as possible in order to provide more specifically preferred embodiments. For example, according to a preferred embodiment, the complex comprise a ligand selected from compounds that meets the definition of two or more of embodiments A to G (the cut-set, overlap or intersection ∩). For example, the complex of the invention comprises a ligand selected from ligands comprising a five-membered heteroring and which ligand has, at the same time, aromatic properties (the overlap of embodiments C and E).

Further particularly preferred embodiments are the overlap of embodiments A and B; A and C; A and D; A and E; A and F. Further preferred embodiments are provided by the overlap of embodiments B and C; B and E; B and F, B and G; B and F. Further preferred embodiments are the overlap of embodiments C and D; C and E; C and F; C and G. Further preferred embodiments are the overlap of embodiments D and E; D and F; D and G. Further preferred embodiments are the overlap of embodiments E and F; E and G. A further preferred embodiment is the overlap of embodiments F and G.

Further preferred embodiments are provided by the overlap of three embodiments selected from embodiments A to G. Such specifically preferred embodiments are provided by the following overlaps of embodiments: A, B and C; A, B and D; A, B, and E; A, B and F; A, B and G; A, C and D; A, C and E; A, C and F; A, C and G; A, D and E; A, D and F; A, D and G; A, E and F; A, E and F; B, C and D; B, C and E; B, C and F; B, C and G; B, D, and E; B, D and F; B, D and G; B, E and F; B, E and G; B, F and G; C, D and E; C, D and F; C, D and G; C, E and F; C, E and G; C, F and G; D, E and F; D, F and G.

For example, the overlap of embodiments A, B and C (underlined above) relates to complexes of the invention comprising a ligand having a five-membered ring (C) containing at least two (A) adjacent (B) heteroatoms. These ligands are those represented by compounds (13), (15) to (18), (23) to (34), (50) to (54), (60) to (63), and the compounds of formulae (1) to (5), (1-2), (2-2), (3-2), (1-3), (2-3), (3-3), (1-4), (2-4), (3-4), in as far as these latter compounds comprise at least one substituent selected from the substituents (B-1), (B-4), (B-6), (B-8), (B-13), (C-1) to (C-8), (D-1) to (D3), (F-1), (F-3), (F-4), (F-6), (G-1), (G-2).

Further preferred embodiments are provided by the overlap of four embodiments selected from embodiments A to G. Such specifically preferred embodiments are provided by the following overlaps of embodiments: A, B, C, and D; A, B, C, and E; A, B, C, and F; A, B, C and G; A, B, D, and E; A, B, D and F; A, B, D and G; A, C, D and E; A, C, D and F; A, C, D and G; A, C, E and F; A, C, E and G; A, D, E and F; A, D, E and G; A, E, F and G; B, C, D and E; B, C, D and F; B, C, D and G; B, C, E and F; B, C, E and G; B, C, F and G; B, D, E and F; B, D, E and G; B, E, F and G; C, D, E and F; C, D, E and G; C, D, F and G; D, E, F and G.

For example, an overlap of embodiments, A, B, C, and G (underlined above), relates to complexes of the invention comprising a bi-or tridentate ligand (La) comprising at least one pyridine ring (G), and a substituent having a five-membered ring (C) containing at least two (A) adjacent (B) heteroatoms. These ligands are those represented by compounds of formulae (1) to (5), (1-2), (2-2), (3-2), (1-3), (2-3), (3-3), (1-4), (2-4), (3-4), in as far as these latter compounds comprise at least one substituent selected from the substituents (B-1), (B-4), (B-6), (B-8), (B-13), (C-1) to (C-8), (D-1) to (D3), (F-1), (F-3), (F-4), (F-6), (G-1), (G-2).

In the embodiments and the preferred, combined or particular embodiments above, embodiment A may be replaced by embodiment A', resulting in the corresponding overlaps in which a ring with exactly two ring heteroatoms is present.

It is further noted that heteroatoms are as defined above, but nitrogen being the preferred ring-heteroatom. According to an embodiment, when there are exactly two or more than two ring-heteroatoms, said heteroatoms are preferably nitrogen atoms.

According to an embodiment, the complex of the invention comprises at least one ligand (La) selected from the compounds of any one of formula (1), (2), (3), (1-2), (2-2), (3-2), (1-3), (2-3), (3-3), (1-4), (2-4), (3-4), said compound being substituted with one, or, if applicable, two or three substituents, of formulae B-8, the other substituents being selected as specified above, but preferably from H, halogen, -CN, -CF₃, and C1-C4 alkyls, C2-C4 alkenyls and C2-C4 alkynyls, wherein in said alkyls, alkenyls and alkynyls one, several or all available hydrogen may be replaced by halogen.

According to an embodiment, the complex of the present invention (e.g. the complex of formula (I)) comprises at least one ligand (e.g. La) selected from the ligands of formulae (64), (65), (66), and (67) below: 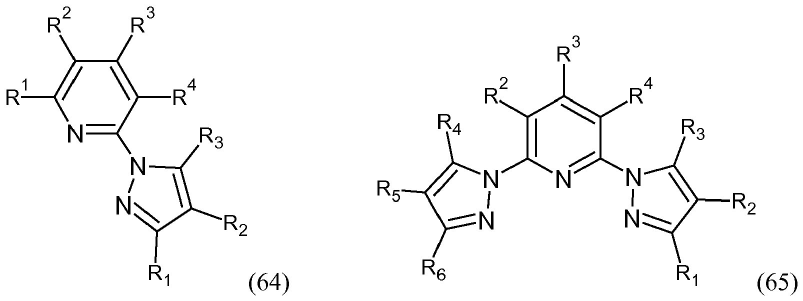 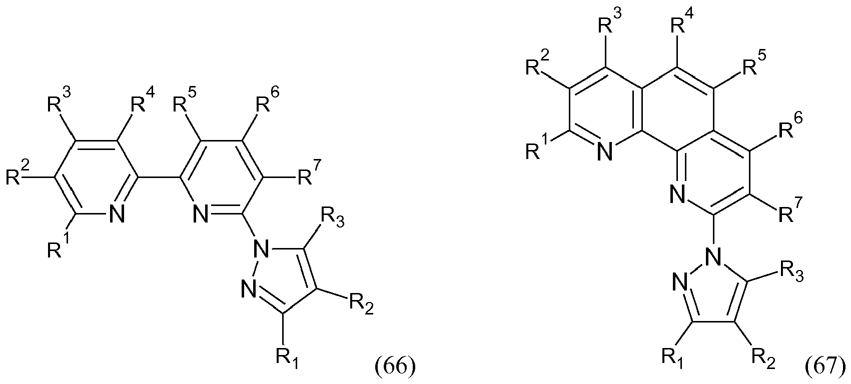 wherein R₁, R₂, R₃, R₄, R₅, R₆, R₇, in as far as applicable, and R₁, R₂, R₃, R₄, R₅, R₆, in as far as applicable, are as defined elsewhere in this specification, in particular according to the preferred embodiments.

Preferably, R¹, R², R³, R⁴, R⁵, R⁶, R⁷, in as far as applicable, and R₁, R₂, R₃, R₄, R₅, R₆, in as far as applicable, in any one of compounds (64), (65), (66), and (67), is preferably selected from H, halogen, -CN, -CF₃, C1-C4 alkyls, C2-C4 alkenyls and C2-C4 alkynyls, wherein in said alkyls, alkenyls and alkynyls one, several or all available hydrogen may be replaced by halogen. According to an embodiment, R¹, R², R³, R⁴, R⁵, R⁶, R⁷ (in as far as applicable) are all H, substituents R₁, R₂, R₃, R₄, R₅, R₆ (in as far as applicable), are as defined above or elsewhere in this specification, but preferably selected from H, -CN, and -CF₃.

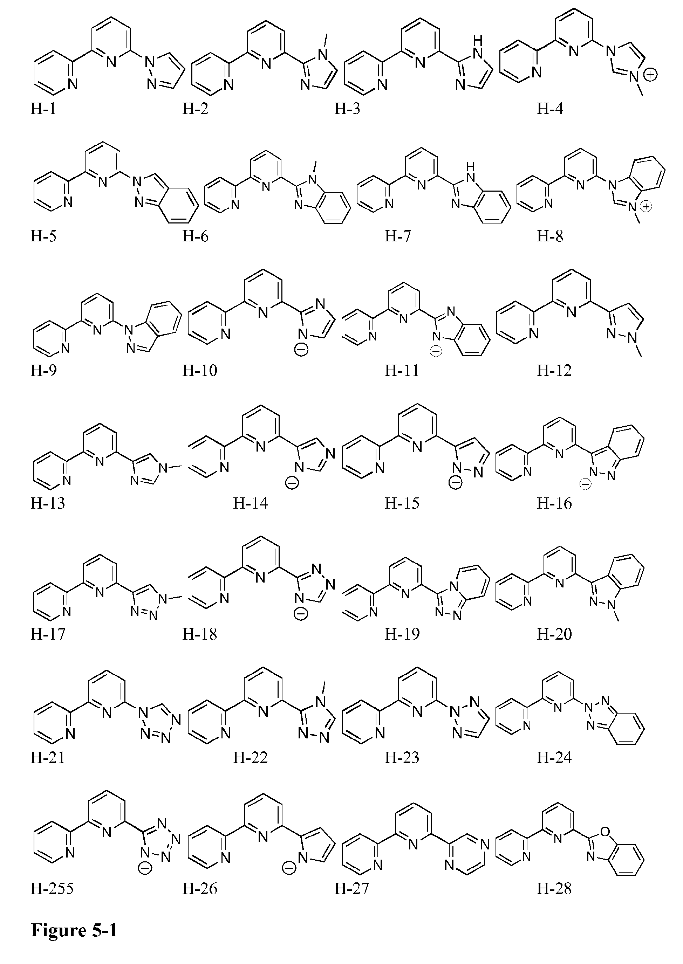

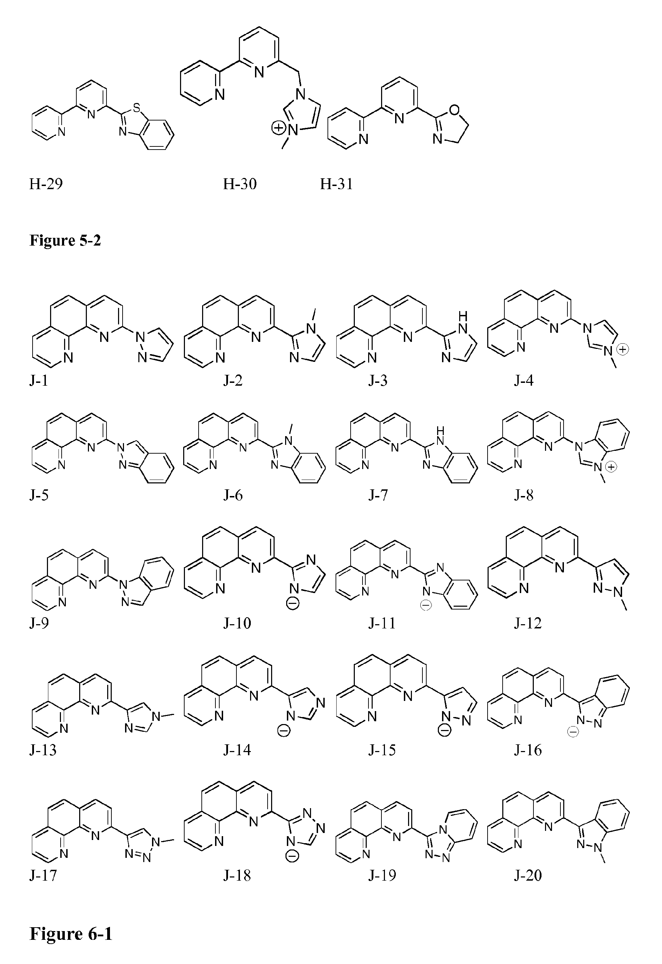

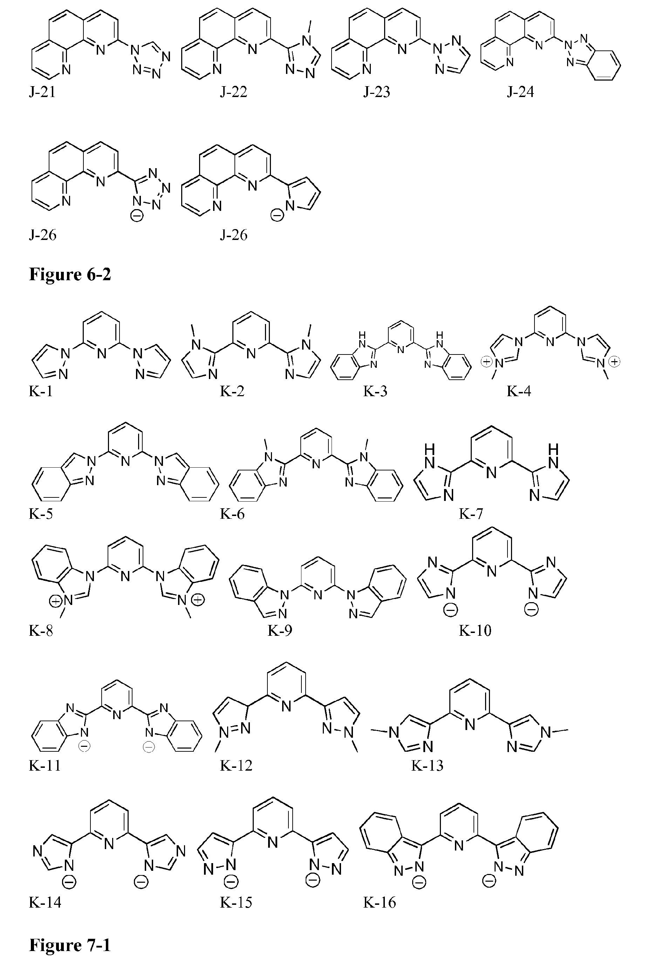

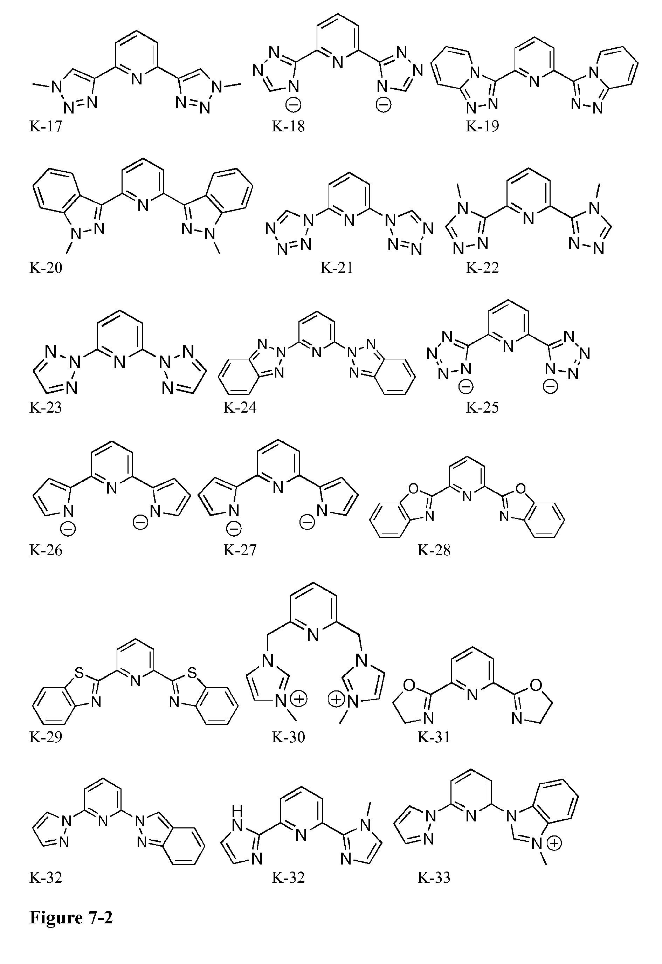

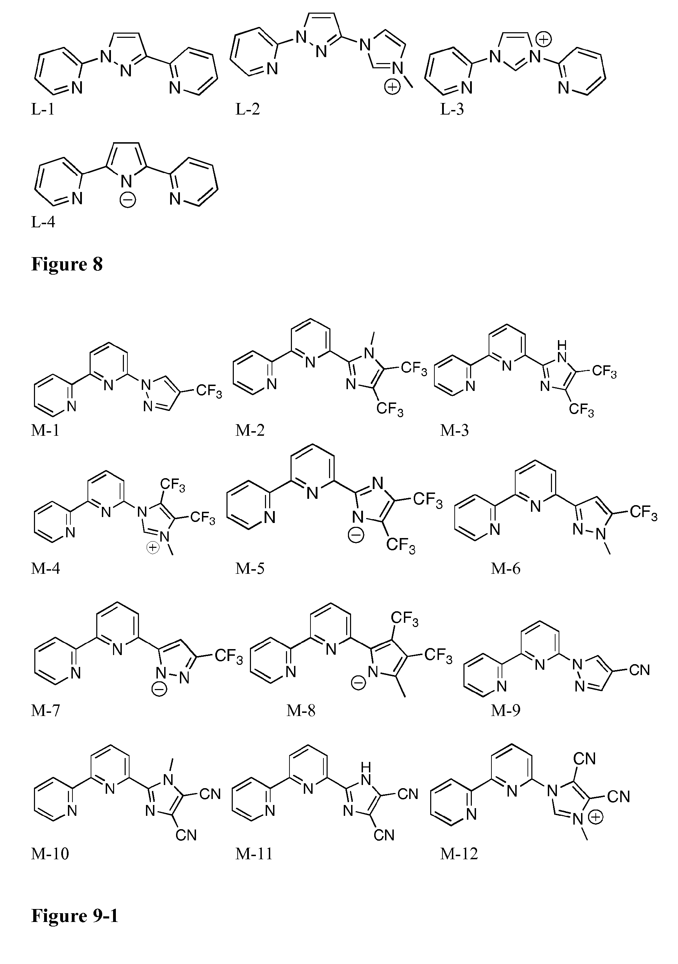

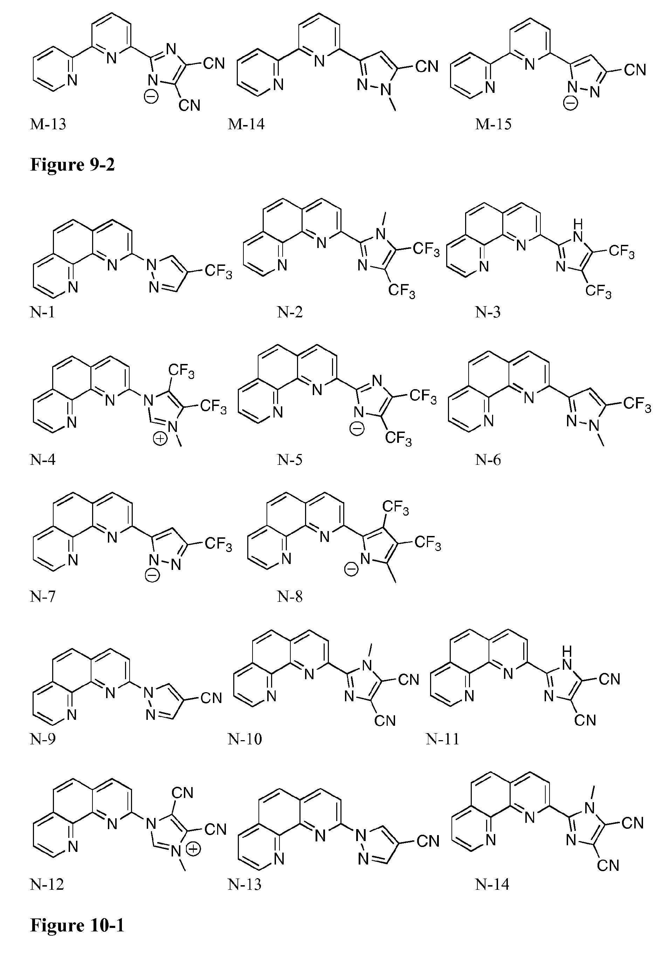

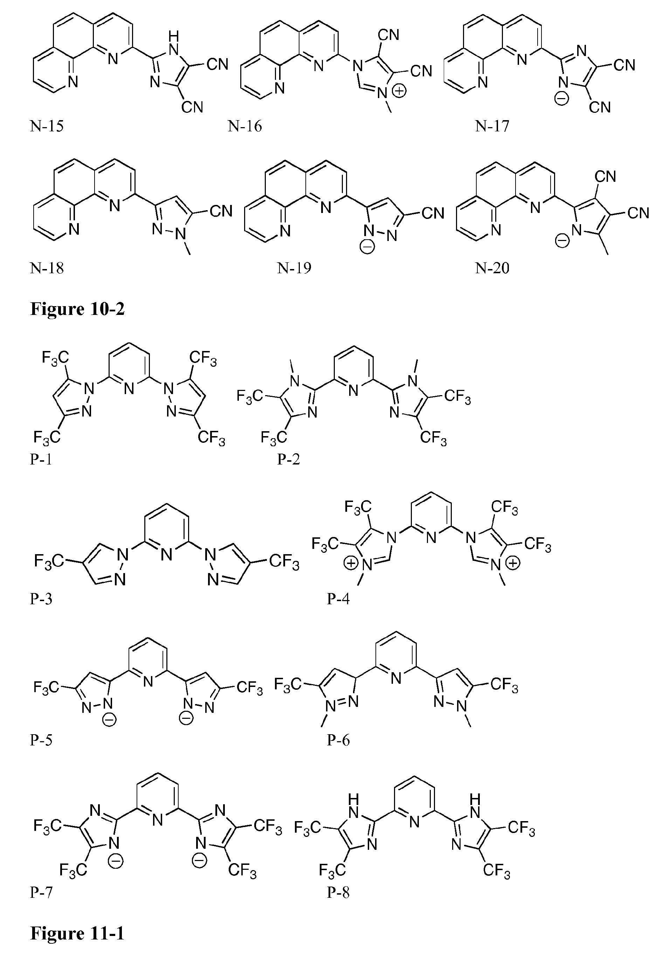

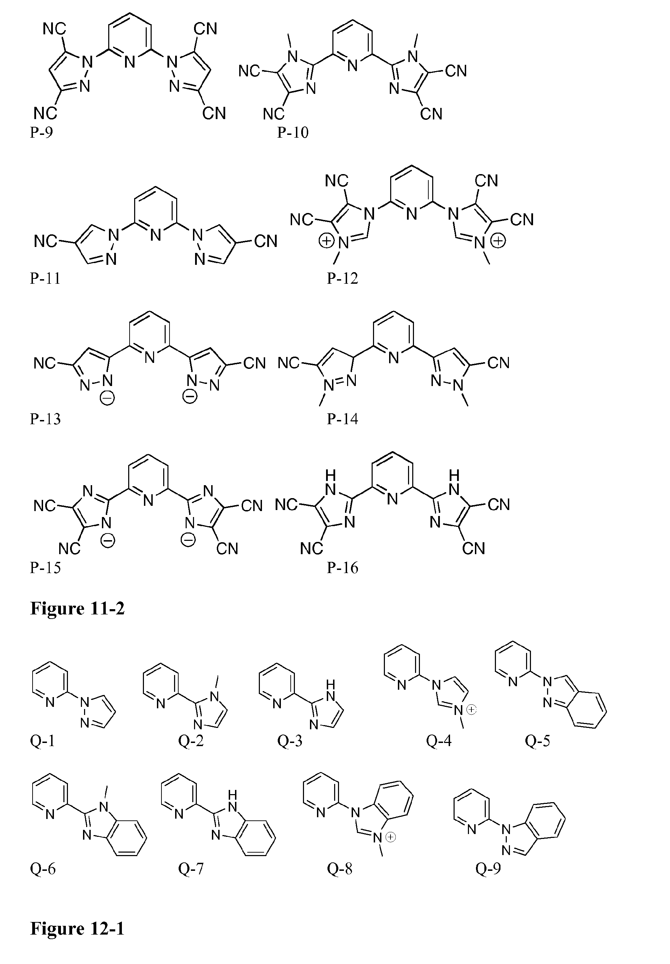

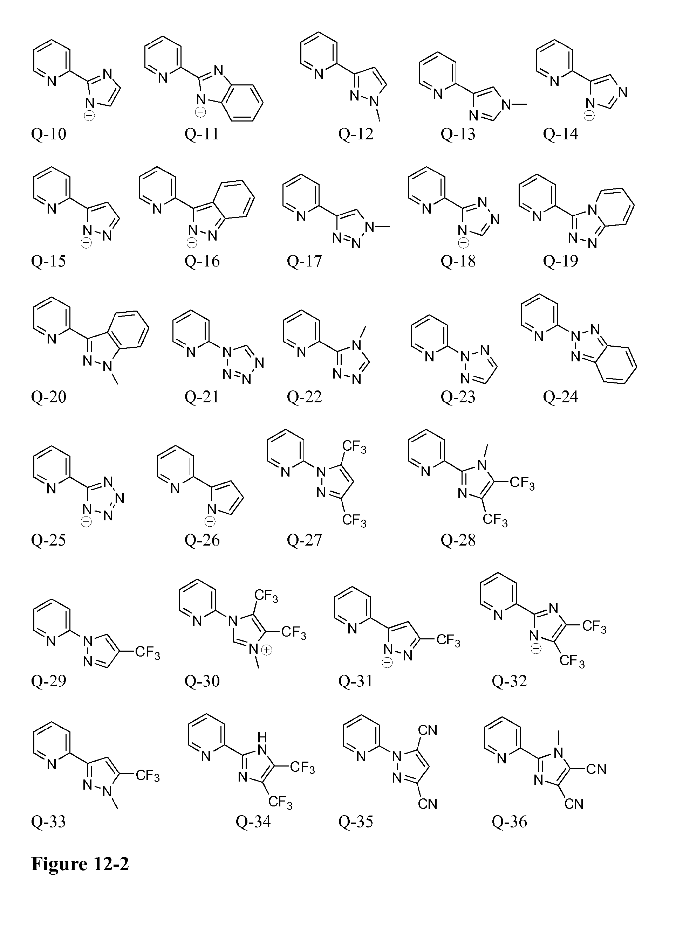

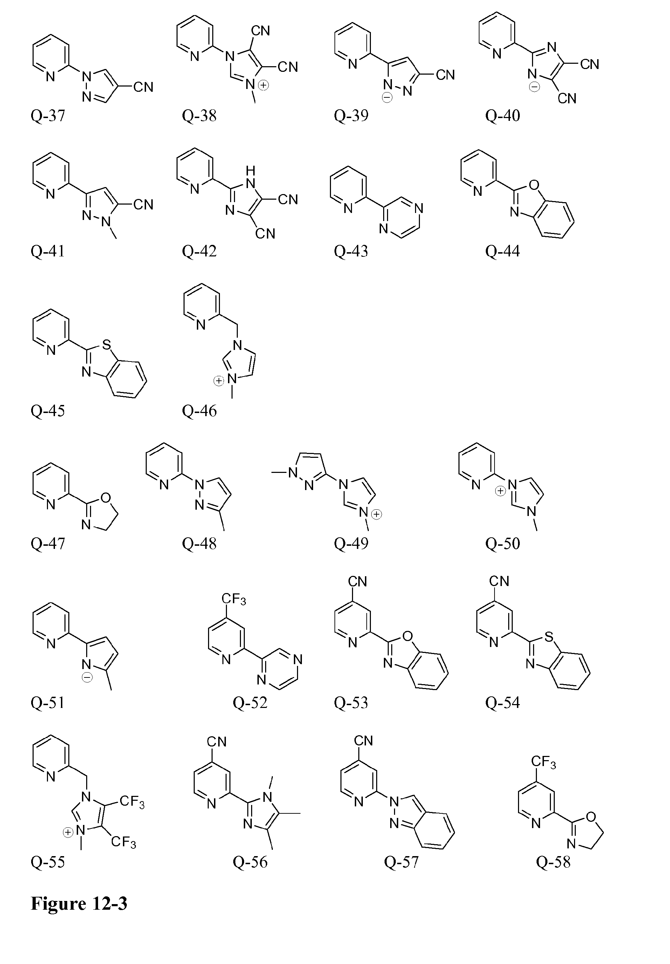

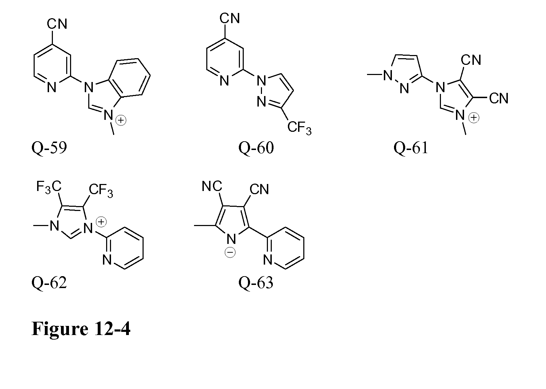

According to an embodiment, at least one, at least two, in case of bidentate ligands, three ligands La is/are selected independently from the compounds shown in Figures 5, 6, 7, 8, 9, 10, 11, and/or 12. Accordingly, one, two or more ligands La may be independently selected from any one of ligands H-1 to H-31, J-1 to J-26, K-1 to K-33, L-1 to L-4, M-1 to M-15, N-1 to N-20, P-1 to P16, Q-1 to Q-63.

According to an embodiment, in compounds H-1 to H-31, J-1 to J-26, K-1 to K-33, L1 to L4, Q-1 to Q-26, Q-43 to Q-51, any one, more than one or all available hydrogen may independently be replaced by a substituent other than H as defined above for R¹ to R⁸, and/or R₁, to R₇, as well as the preferred embodiments of R¹ to R⁸, and R₁, to R₇ that are other than H. It is noted that in the other exemplary ligands (M-1 to M-15, N-1 to N-20, P-1 to P-16, Q-27 to Q-42 and Q-52 to Q-63) shown in the figures, substituents replacing available hydrogens are already present, these latter exemplary ligands thus form specific examples of ligands comprising such hydrogen replacing substituents.

Furthermore, in sever of the ligands shown in Figures 5 to 12, methyl substituents on nitrogen atoms corresponding to R' and R" as defined elsewhere in this specification are present (for example, H-2, H-4, H-6, H-8, etc). These N-methyl substituents may, according to an embodiment, be replaced by other substituents as defined for R' and R" elsewhere in this specification, in particular above.

According to an embodiment, in compounds H-1 to H-31, J-1 to J-26, K-1 to K-33, L1 to L4, Q-1 to Q-26, Q-43 to Q-51, any one, more than one or all available hydrogen may independently be replaced by -F, -Cl, -Br, -I, (halogen), -NO₂, -CN, -OH, -CF₃, substituted or unsubstituted C1-C50 alkyl, C2-C50 alkenyl, C2-C50 alkynyls, and C5 to C50 aryl as defined above for R¹ to R⁸, and/or R₁, to R₇, as well as the preferred embodiments of R¹ to R⁸ and R₁, to R₇ that are other than H.

In particular in any ligand La selected from compounds H-1 to H-31, J-1 to J-26, K-1 to K-33, L1 to L4, Q-1 to Q-26, Q-43 to Q-51, any one, more than one or all available hydrogen may independently be replaced by halogen, -CN, C1-C6 alkyls, C2-C6 alkenyls C2-C6 alkynyls, and C6-C 10 aryls, wherein in said alkyls, alkenyls, alkynyls and aryls one, several or all available hydrogen may be replaced by halogen, -CN and -CF₃.

More preferably, in in any ligand La selected from compounds H-1 to H-31, J-1 to J-26, K-1 to K-33, L1 to L4, Q-1 to Q-26, Q-43 to Q-51, any one, more than one or all available hydrogen may independently be replaced by halogen, -CN, C1-C4 alkyl, wherein in said alkyl one, several or all available hydrogen may be replaced by halogen, -CN and -CF₃.

Other ligands of the complex of the invention, in particular ligands Xb (X1, ... , Xm) of the complex of formula (I), may, for example, be selected from: H₂O Cl⁻, Br⁻, I⁻, CN⁻, NCO⁻, NCS⁻, NCSe⁻, NH₃, CO, PR3 (R is independently selected from substituted and unsubstituted C6-C18, preferably C6-C12 aryl and/or aroxyl (for example phenyl or phenoxyl); substituted and unsubstituted C1-C18, preferably C1-10, more preferably C1-C4 alkyl and/or alkoxyl; imidazole, substituted imidazoles; pyridines, substituted pyridines; pyrazoles, substituted pyrazoles; triazoles; pyrazine; for example. Preferably, the ligands Xb (X1, ... , Xm) are selected from H₂O Cl⁻, Br⁻, I⁻, CN⁻, NCO⁻, NCS⁻, NCSe⁻, NH₃, CO, and PR3 (R is as above, preferably independently selected from phenyl, phenoxyl, alkyl and alkoxyl).

The present invention also relates to electrochemical or optoelectronic device comprising the complex of the invention. In particular, the complex of the invention is preferably used as a redox-couple, the oxidized and reduced counterparts of the complex forming a redox pair. The redox pair is preferably formed by two oxidation states of the metal atom in the complex. According to an embodiment, the redox-couple is preferably suitable for a monoelectronic redox process. For example, +I/+II or +II /+III or +III/+IV if M is Cobalt or +I/+II if M is Copper, just to mention some non-limiting possibilities.

The device of the invention may be a photo-electrochemical device, an optoelectronic device, an electrochemical battery, for example a lithium ion battery, a double layer capacitor, a light emitting device, an electrochromic or photo-electrochromic device, an electrochemical sensor, a biosensor, an electrochemical display and an electrochemical capacitor, for example a super capacitor. According to a preferred embodiment, the electrochemical device is a photoelectrical conversion device, in particular a solar cell.

The device of the invention is preferably a photovoltaic device.

According to an embodiment, the device of the invention is a dye-sensitized solar cell (DSSC).

The electrochemical device of the invention is preferably a regenerative device.

According to an embodiment, the electrochemical and/or optoelectronic device of the invention comprises a first and a second electrode and, between said first and second electrode, an electrolyte and/or an intermediate layer, said electrolyte or said intermediate layer comprising the metal complex according to the invention.

According to an embodiment, the first electrode is a photo electrode and the second electrode is a counter electrode. Between said photo electrode and said counter electrode there is preferably said intermediate layer, said intermediate layer comprising the complex of the present invention. Said first electrode, intermediate layer and second electrode are preferably connected in series.

The device of the invention may further comprise one or more substrate layers, for example supporting one of the electrodes, preferably the photo electrode. The substrate layer may be made from plastic or from glass. In flexible devices, the substrate is preferably made from plastic.

The electrochemical /optoelectronic device of the present invention generally has two conductive layers, wherein a first conductive layer is required for removing the electrons generated from the device, generally at the first electrode, and a second conductive layer for supplying new electrons, or, in other words, removing holes, generally at the second electrode. The second conductive layer is generally part of the counter electrode and may be already part of a substrate layer, as is the case, for example with ITO (indium tin oxide)-coated plastic or glass, where the transparent ITO is coated on the plastic or glass and makes the later electrically conductive.

The device of the present invention generally comprises a counter electrode (a second electrode), which faces the intermediate or electrolyte layer towards the inside of the device, and the substrate on the outside of the cell, if such substrate is present. The counter electrode generally comprises a catalytically active material, suitable to provide electrons and/or fill holes towards the inside of the device. The counter electrode may thus comprises materials selected from material selected from Pt, Au, Ni, Cu, Ag, In, Ru, Pd, Rh, Ir, Os, C, conductive polymer and a combination of two or more of the aforementioned, for example. Conductive polymers may be selected from polymers comprising polyaniline, polypyrrole, polythiophene, polybenzene and acetylene, for example.

In dye sensitized solar cells, at least part of the photo electrode contains a sensitizer layer towards the inside of the cell/device, thereby forming a light absorption layer, which thus comprises at least two separate layers, namely a porous semiconductor layer and, absorbed thereon, a layer of sensitising dyes. The porous semiconductor layer may be produced by processes described in the art (B. O'Reagan and M. Grätzel, Nature, 1991, 353, 373) from semiconductor nanoparticles, in particular nanocrystalline particles. Such particles generally have a mean diameter of about 0-50nm, for example 5-50 nm. Such nanoparticles may be made from a material selected from the group of Si, TiO₂, SnO₂, ZnO, WO₃, Nb₂O₅ and TiSrO₃, for example.

The dye layer comprises, besides optional co-adsorbed compounds, such as those disclosed in WO2004/097871A1, for example, at least one dye or sensitizer, or a combination of two or more different sensitizers. For example, the dye may be an organo-metallic compound. Examples for organometallic compounds encompass ruthenium dyes, as they are currently used in such devices. Suitable ruthenium dyes are disclosed, for example, in WO2006/010290.

The dye layer may comprise organic sensitizers. For example, the device may be free of any sensitizer using ruthenium or another noble metal.

The intermediate or electrolyte layer of the device of the present invention preferably has the general purpose of mediating the regeneration of electrons. For example in the dye of a DSSC, electrons were removed due to radiation and need to be regenerated. The electrons are generally provided by the counter electrode, and the intermediate layer thus mediates the transport of electrons from the counter electrode to the dye, or of holes from the dye to the counter electrode. The transport of electrons and/or holes may be mediated by electrically conductive materials as such and/or by diffusion of charged molecules having a suitable redox potential. Accordingly, the intermediate layer may be an electrolyte layer and/or an electrically conductive charge transport layer, for example.

According to a preferred embodiment of the invention, the intermediate layer may contain a solvent or may be substantially free of a solvent. This also applies generally for the electrolyte of the invention. Generally, there is a solvent if the solvent provides 0.5% or more, 1% or more, preferably 5% or more, more preferably 10% or more and most preferably 20% or more of the weight of this layer.

Preferably, the intermediate layer or the electrolyte comprises the complex of the present invention. The complex may, for example, be added in the form of a salt, or, if the complex is neutral, in any isolated or purified form, for example.

According to an embodiment, the intermediate layer is an electrolyte comprising one or more ionic liquids.

Electrolytes comprising as a major component ionic liquids (ionic-liquid based electrolytes) are, disclosed, for example, in WO2007/093961. Solvent free electrolytes produced from eutectic melts, are disclosed in the international patent application WO 2009/083901, and are also encompassed by the present invention.

The intermediate layer or electrolyte may also be an electrically conductive charge transport layer, in which electrons and/or holes move by electronic motion, instead of diffusion of charged molecules. Such electrically conductive layers may, for example, be based on organic compounds, including polymers. Accordingly, this layer may be an electron and/or hole conducting material. U. Bach et al. "Solid-state dye-sensitized mesoporous TiO2 solar cells with high photon-to-electron conversion efficiencies", Nature, Vol. 395, October 8, 1998, 583-585, disclose the amorphous organic hole transport material 2,2',7,7'-tetrakis(N,N-di-p-methoxyphenyl-amine)9,9'-spirofluorene (OMeTAD) in dye-sensitised solar cells. In WO2007/107961, charge transporting materials, which are liquid at room temperature and their application in dye-sensitized solar cells are disclosed. These and other materials may be used, for example, for the purpose of the present invention.

Both, said electrolyte or charge transport layer may comprise additives for improving the performance of the device, such as dopants in the case of charge transporters, and the like.

According to an embodiment, the complex of the invention may be used as a dopant in a charge transporting material, preferably an organic charge transporting material, in the electrochemical and/or optoelectronic device of the present invention.

According to another embodiment, the electrolyte and/or the intermediate layer is a solvent based electrolyte.

The solvent, if present, is preferably an organic solvent. Examples of the organic solvent include: alcohol solvents such as methanol, ethanol, t-butanol and benzylalcohol; nitrile solvents such as acetonitrile, propionitrile and 3-methoxypropionitrile; nitromethane; halogenated hydrocarbons such as dichloromethane, dichloroethane, chloroform and chlorobenzene; ether solvents such as diethylether and tetrahydrofuran; dimethylsulfoxide; amide solvents such as N,N-dimethylformamide, N-methylformamide, formamide, N-methylacetamide, N,N-dimethylacetamide, N-methylpropioneamide, and the like. N-methylpyrrolidone, 1,3-dimethylimidazolidinone, 3-methyloxazolidinone, ester solvents such as ethyl acetate and butylacetate; carbonate solvents such as diethyl carbonate, ethylene carbonate and propylene carbonate; ketone solvents such as acetone, 2-butanone and cyclohexanone; hydrocarbon solvents such as hexane, petroleum ether, benzene and toluene; sulforane; N,N,N',N'-tetramethyl urea; etc.. Among these solvents, nitrile solvents and amide solvents are preferred. C1-C5 alkyl or C1-C5 alkoxynitrile solvents are particularly preferred (see examples above). The solvents can be used alone or in combination.

The intermediate layer and/or the electrolyte preferably comprises additives designed to improve stability and/or the performance characteristics of the device, such as N-alkyl-benzimidazole, wherein the alkyl is a C1-C10 alkyl, which may be halogenated, for example, Guanidinium thiocyanate, substituted pyridines and bases having pKa between 3 to 6.

The present invention will now be illustrated by way of examples. These examples do not limit the scope of this invention, which is defined by the appended claims.

### Examples:

### Example 1: Synthesis of Bipyridine-Pyrazole Ligand

tBuOK (2g) was added to a suspension of pyrazole (1 g) in dmso (80 mL) and stirred until a clear solution has formed. 6-chloro-2,2'-bipyridine (1g, from HetCat) was added slowly by portion and the mixture heated at 140 °C for 14 hours. After cooling down to room temperature, water was added and the precipitate filtered and wash with water. The compound was further purified by silica gel chromatography column using Ethyl acetate/diethyl ether as eluent, leading to an off-white crystalline solid (450 mg, yield 39 %). Spectroscopic analysis are as reported in the literature (Inorg. Chem. 1991, 30, 3733).

### Example 2: Synthesis of CoII Complex [Co(II)(bby-pz)₂](PF6)₂

91 mg (0.382 mmol, excess) of CoCl₂*6H₂O were dissolved in 25 mL of water while in another flask 93 mg (0.418 mmol) of the pyridine-pyridine-pyrazole ligand of Example 1 were dissolved in 25 mL of acetone. The solutions were combined and heated to 55°C for 2h. Then 400 mg of NH₄PF₆ dissolved in 100 mL of water were added to the mixture. The mixture was stored overnight at 3 °C for precipitation. Then the product was collected on a sintered glass frit and dried in vacuo. The pure product was obtained as orange solid and contained compound (70) shown below. Yield: 95 mg (0.12 mmol, 57%). ¹H NMR (400 MHz, acetone-D6): δ 112.95 (s, 2H, ArH), 91.83 (s, 2H, ArH), 89.23 (s, 2H, ArH), 75.68 (s, 2H, ArH), 69.31 (s, 2H, ArH), 66.22 (s, 2H, ArH), 43.00 (s, 2H, ArH), 40.74 (s, 2H, ArH), 19.01 (s, 2H, ArH), 13.61 (s, 2H, ArH) ppm.

### Example 3: Synthesis of CoIII Complex [Co(III)(bpy-pz)₂](PF6)₃

91 mg (0.382 mmol, excess) of CoCl₂*6H₂0 were dissolved in 25 mL of water while in another flask 93 mg (0.418 mmol) of the pyridine-pyridine-pyrazole ligand of Example 1 were dissolved in 25 mL of methanol. The solutions were combined and heated to 55°C for 2h. The mixture was allowed to cool to room temperature and then H₂O₂ (1 mL, 30%) and HCl (1 mL, 25%) were added to oxidize the cobalt. The mixture was stirred for 1 h and then 400 mg of NH₄PF₆ dissolved in 100 mL of water were added to the mixture. The mixture was stored overnight at 3 °C for precipitation. Then the product was collected on a sintered glass frit and dried *in vacuo*. The product was obtained as orange solid and contained 65 % of the desired Co(III) complex (compound (71)) and 35 % of the corresponding Co(II) complex. Yield: 97 mg (0.10 mmol, 49%). ¹H NMR (400 MHz, acetone-D6): δ 9.41-9.26 (m, 3H, ArH), 9.00 (t, ³*J*_{HH} = 9.3 Hz, 2H, ArH), 8.47 (t, ³*J*_{HH} = 7.6 Hz, 1H, ArH), 7.92 (d ³*J*_{HH} = 5.8 Hz, 1H, ArH), 7.84 (s, 1H, ArH), 7.62 (t, ³*J*_{HH} = 6.7 Hz, 1H, ArH), 6.86 (s, 1H, ArH) ppm.

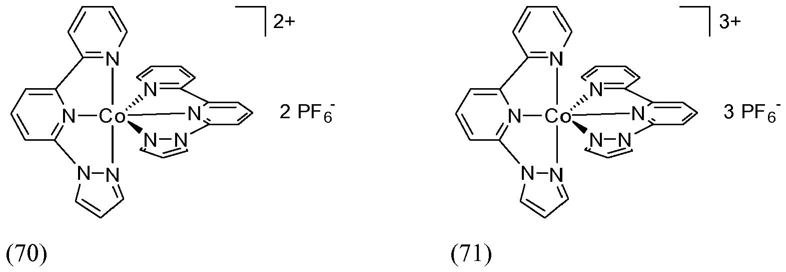

### Example 4: Synthesis of Coll Complex with bidentate ligands [Co(II)(py-pz)₃](PF6₂)

Pyridine-pyrazole was obtained as disclosed in Chemishe Berichte, 1996, 129, 589.

225 mg (1.55 mmol, 3.1 eq) of pyridine-pyrazole ligand were dissolved in 20 mL of MeOH and then 119 mg (0.5 mmol, 1 eq) of CoCl₂*6H₂O were added as a solid. The mixture was heated to reflux for 2h. After colling to r. t. excess of KPF₆ dissolved in MeOH was added to the mixture. The mixture was stored at 3 °C for precipitation. After 3h the product was collected on a sintered glass frit and dried in vacuo. The pure product was obtained as orange crystals, containing compound (72). Yield: 246 mg (0.33 mmol, 66%).

### Example 5: Synthesis of CoIII Complex with bidentate ligands [Co(III)(py-pz)₃](PF6₃)

218 mg (1.5 mmol, 3.0 eq) of pyridine-pyrazole ligand were dissolved in 10 mL of water and heated to 75 °C until complet solution occurred. Then 119 mg (0.5 mmol, 1 eq) of CoCl₂*6H₂O were added to the colourless solution. To the pink solution H₂O₂ (1 mL, 30%) and HCl (1 mL, 25%) were added to oxidize the cobalt. After 10 min. 460 mg (2.5 mmol, 5 eq) of KPF₆ dissolved in 10 mL of hot water were added drop wise to the mixture. Precipitation occurred and the mixture was allowed to cool to room temperature. The product was collected on a sintered glass frit and dried in vacuo. The pure product was obtained as orange solid and contains compound (73). Yield: 259 mg (0.28 mmol, 56%). ¹H NMR (400 MHz, acetone-D6): δ 9.56-9.53 (m, 3H, ArH), 8.73-8.64 (m, 6H, ArH), 8.01-7.81 (m, 9H, ArH), 7.27-7.23 (m, 3H, ArH) ppm.

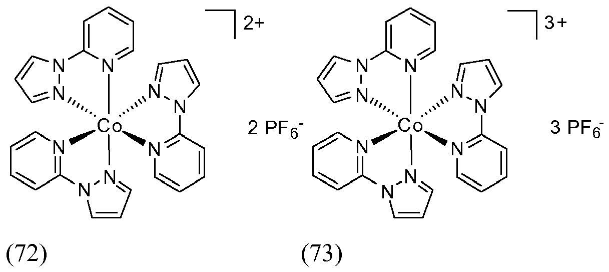

### Example 6: Synthesis of an organic dye (Y123)

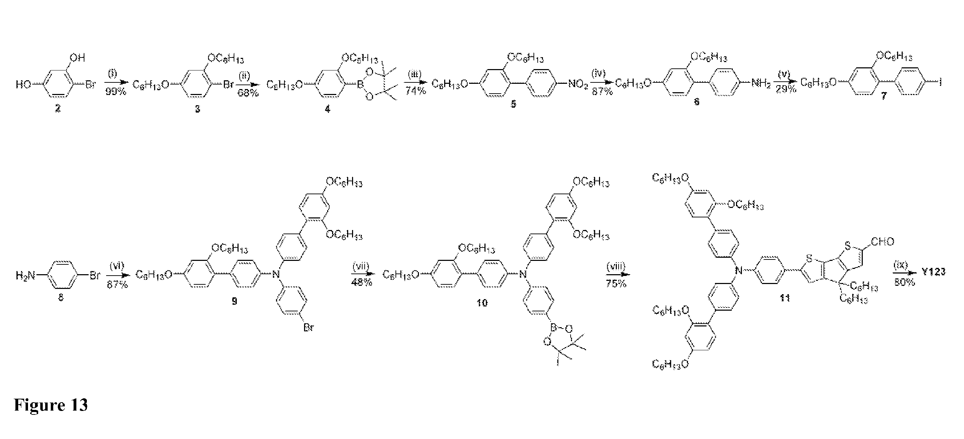

Dye Y123 (3-{6-{4-[bis(2',4'-dihexyloxybiphenyl-4-yl)amino-]phenyl}-4,4-dihexyl-cyclopenta-[2,1-b:3,4-b']dithiphene-2-yl}-2-cyanoacrylic acid) is prepared in accordance with the scheme shown in Figure 13.

### Example 7: Preparation of a Dye Sensitized Solar Cell Using the Complex-Based Redox-Couple

TiO₂ electrodes were prepared of 2.5 - 3 µm transparent layer (20 nm diameter anatase particles), in accordance with the literature (Yum, J. H.; Jang, S. R.; Humphry-Baker, R.; Grätzel, M.; Cid, J. J.; Torres, T.; Nazeeruddin, M. K. Langmuir 2008, 24, 5636). The TiO₂ electrodes were immersed into a 0.1 mM solution of dye Y123 obtained in Example 6 in *tert*-butanol/acetonitrile mixture (1:1 v/v) and kept at room temperature for 15 hrs.

The applied electrolyte is consisted of 0.17 - 0.2 M [Co(II)(bpy-pz)₂](PF6)₂, 0.04 - 0.05 M [Co(III)(bpy-pz)₂](PF6)₃, 0.1M LiClO₄, and 0.25M *tert*-butylpyridine in acetonitrile.

The dye-adsorbed TiO₂ electrode and thermally platinized counter electrode were assembled into a sealed sandwich type cell with a gap of a hot-melt ionomer film, Surlyn (25 µm, Du-Pont). In order to reduce scattered light from the edge of the glass electrodes of the dyed TiO₂ layer, a light shading mask was used onto the DSCs, so the active area of DSCs was fixed to 0.2 cm². For photovoltaic measurements of the DSCs, the irradiation source was a 450 W xenon light source (Osram XBO 450, Germany) with a filter (Schott 113), whose power was regulated to the AM 1.5G solar standard by using a reference Si photodiode equipped with a colour matched filter (KG-3, Schott) in order to reduce the mismatch in the region of 350-750 nm between the simulated light and AM 1.5G to less than 4%. The measurement of incident photon-to-current conversion efficiency (IPCE) was plotted as a function of excitation wavelength by using the incident light from a 300 W xenon lamp (ILC Technology, USA), which was focused through a Gemini-180 double monochromator (Jobin Yvon Ltd.).

The results are summarized in Table 1 below.

**Table 1. Current (I)-Voltage (V) characteristic of dye-sensitized solar cell composed of Y123 dye with Cobalt based redox couples under various light intensities.**

| Redox couple | TiO₂ (µm) | *I₀* (% Sun) | *J_{SC}* (mA/cm²) | *V_{OC}* (mV) | Fill factor | PCE (%) |
|---|---|---|---|---|---|---|
| Examples 4 and 5 | 2.7 | 9.5 | 0.63 | 905 | 0.64 | 3.83 |
| | | 51 | 2.50 | 991 | 0.61 | 2.90 |
| | | 100 | 3.75 | 1020 | 0.59 | 2.26 |
| Examples 2 and 3 | 2.7^{[a]} | 9.5 | 1.07 | 974 | 0.67 | 7.34 |
| | | 51 | 5.38 | 1040 | 0.66 | 7.21 |
| | | 100 | 9.37 | 1060 | 0.64 | 6.33 |
| | 2.7 | 9.5 | 1.05 | 943 | 0.81 | 8.39 |
| | | 51 | 5.49 | 999 | 0.76 | 8.12 |
| | | 100 | 10.4 | 1020 | 0.70 | 7.42 |
| | 5.5^{[b]} + 4 | 9.5 | 1.32 | 935 | 0.75 | 9.77 |
| | | 51 | 7.07 | 995 | 0.75 | 10.3 |
| | | 100 | 13.5 | 1010 | 0.70 | 9.52 |

| | | | | | | |
|---|---|---|---|---|---|---|
| [a] The electrolyte consists of 80% concentration of Co^{2+/}Co³⁺ tridentate redox system, [b] The average 20 nm sized TiO₂ anatase with average 32 nm sized pore was used. | | | | | | |

The results in Table 1 show that all the open circuit voltage (*V_{OC}*) of Co^{2+/}Co³⁺ are over 900 mV under 10% light intensity and they augment over 1000 mV under full sun condition. In particular, Co^{2+/}Co³⁺ tridentate system showed promising results in terms of the power conversion efficiency. Dye-sensitized solar cells supported by the 2.7 µm TiO₂ yielded 10.4 mA/cm² of the short circuit current (*J_{SC}*), 1020 mV of *V_{OC}*, 0.70 of the fill factor (*ff*) and the corresponding power conversion efficiency (PCE) of 7.42%. It should be here noted that 1060 mV of the *V_{OC}* is feasible by tuning the redox concentration (see Table 1).

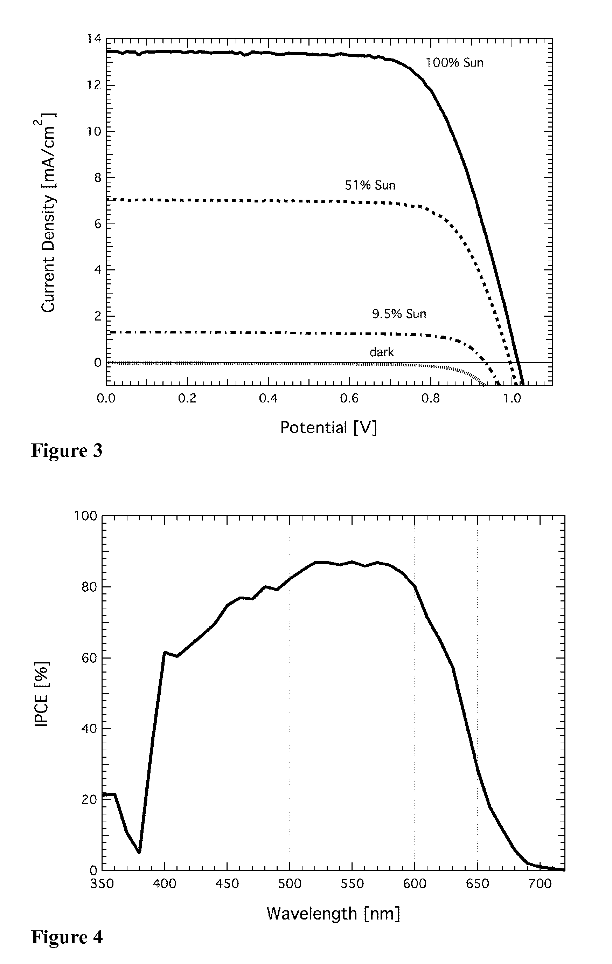

In another example, the TiO₂ double layer composed of 5.5 µm transparent nanocrystalline TiO₂ layer and 4 µm scattering layer (400 nm sized particles) was used for the photo-anode. The result in Table 1 and Figure 3 showed an increase in *J_{SC}* to 13.5 mA/cm² as retaining a high *V_{OC}*, 1010 mV. Overall, the PCE improved to 9.52% under full sun and over 10% under 50% sun. The integration of the incident-photon to current conversion efficiency (IPCE) (shown in Figure 4) over the AM-1.5 solar emission gave J_{SC} values of 13.4 mA/cm² in good agreement with the *I-V* measured values. The high IPCE reaching over 85% near the maximum around 550 nm was observed.

For comparison, the CoII Complex of tris bipyridine [Co(II)(bpy)₃](PF6)₂ (Feldt, S. et al., J. Am. Chem. Soc. 2010, 132, 16714-16724) gave 920 mV, which is 140 mV less than the new electrolyte.

These results show that the redox-couples according to the invention are suitable to adjust and in particular to increase the oxidation potential of the redox mediator, thereby increasing the open circuit voltage of the solar cells. This is an important advantage with respect to iodide/triiodide based redox couple, the oxidation potential of which cannot be substantially changed. Never were such high *V_{OC}* obtained based on the I⁻/I₃⁻ redox couple. It is in particular surprising that impressive conversion efficiencies (PCE) of over 10% were obtained without any further optimization of the tested system.

## Claims

1. A complex of formula I:
M (La)ₙ (Xb)ₘ (I)
wherein:
M is a 1^{st} row transition metal, for example Cobalt;
n is an integer from 1 to 6 and a is a consecutive number of a first set consisting of the integers of 1 to n (1 , ..., n), so that there are n ligands L1, ... , Ln;
m is 0 or an integer from 1 to 5 and b is a consecutive number of a second set consisting of 0 and integers of 1 to m (0, ..., m), so that if m>0 there are m ligands X1, .. , Xm;
wherein n and m equal the appropriate number of ligands present on metal M;
any La (L1, ... , Ln) is independently selected from a mono-, bi-, or tridentate ligand, with the proviso that at least one of La (L1, ... , Ln) comprises a substituted or unsubstituted ring or ring system comprising a five-membered N-containing heteroring and/or a six-membered ring comprising at least two heteroatoms, at least one of which being a nitrogen atom, said five- or six-membered heteroring, respectively, comprising at least one double bond;
Xb is independently a monodentate co-ligand.

2. The complex of claim 1, wherein at least one of said n ligands La (L1, ... , Ln) comprises a pyridine ring or a ring system comprising a pyridine ring connected by a covalent bond or fused to said five-membered heteroring and/or to said six-membered ring comprising at least two heteroatoms, wherein said pyridine ring or a ring system comprising a pyridine ring may or may not be further substituted.

3. The complex of any one of the preceding claims, wherein any one of said n ligands La (L1, ... , Ln) is, independently, selected from compounds of formulae (1)-(63) below: 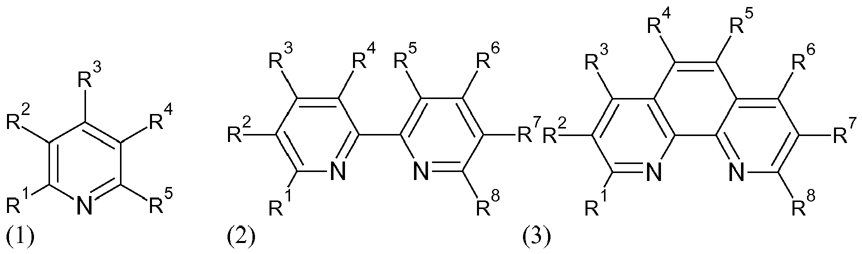 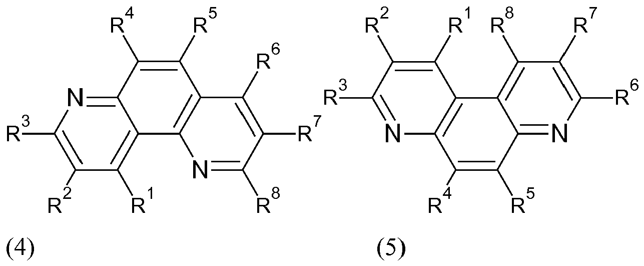 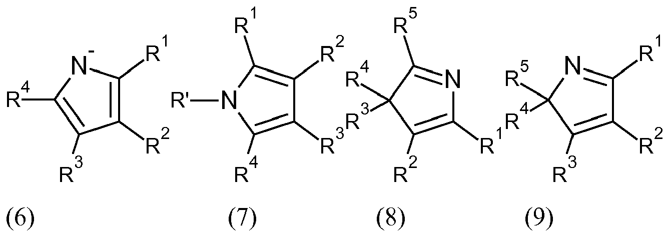 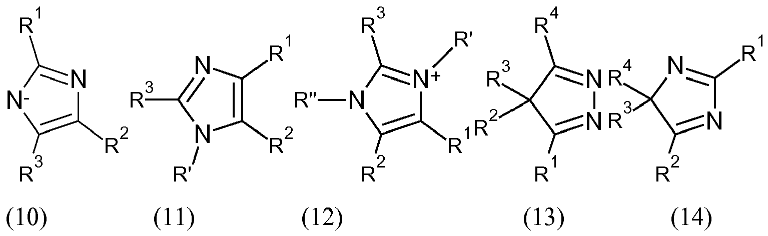 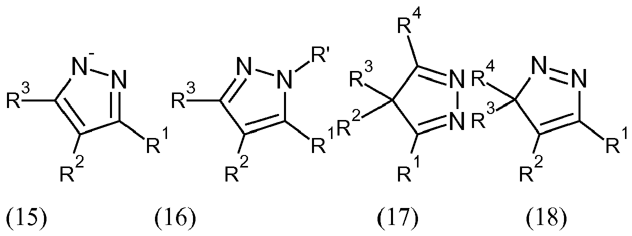 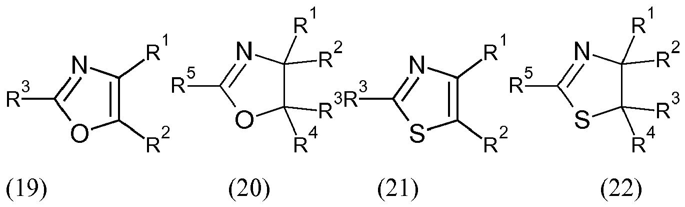 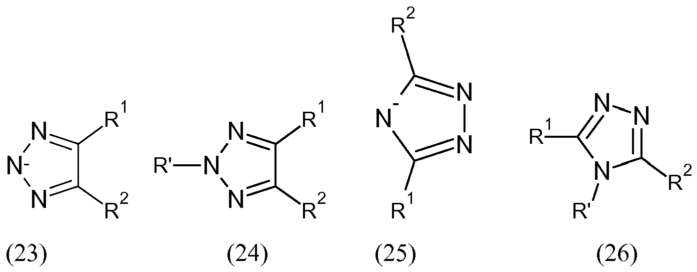 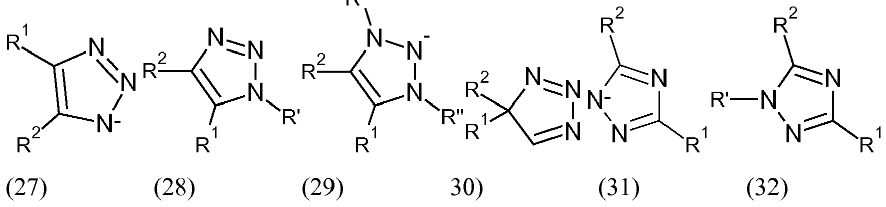 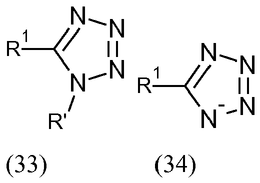 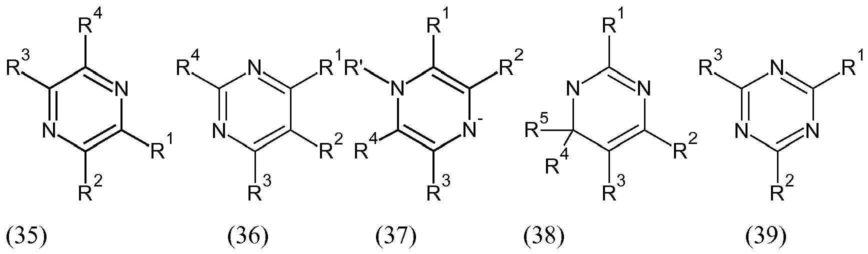 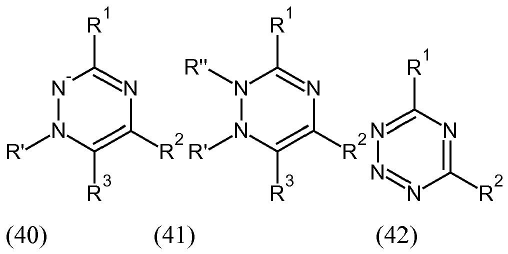 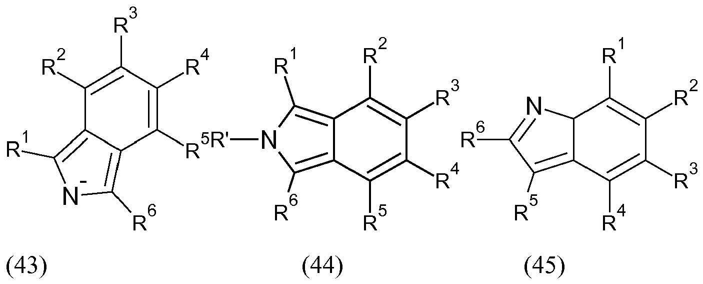 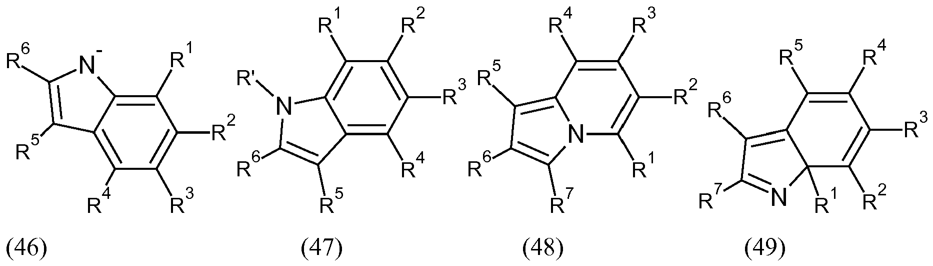 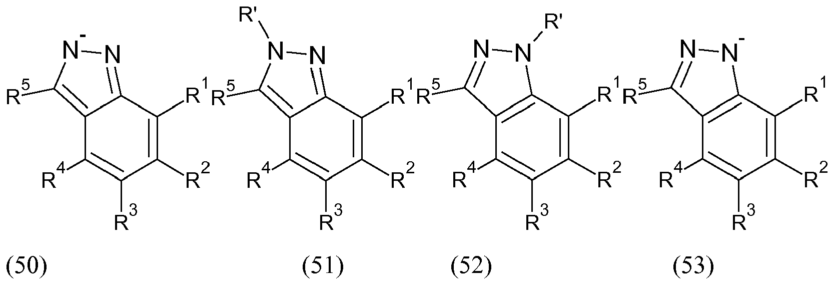 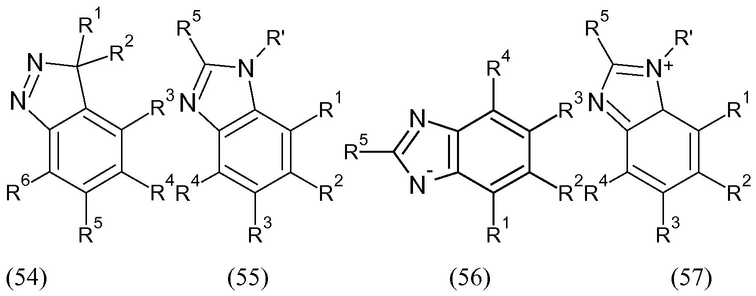 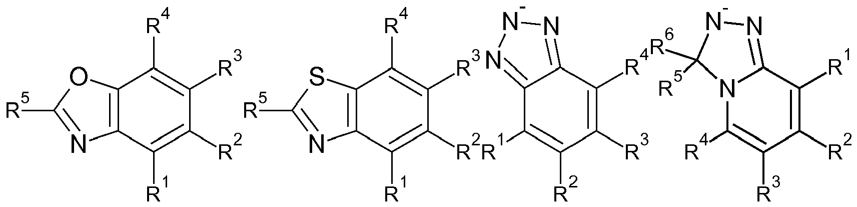 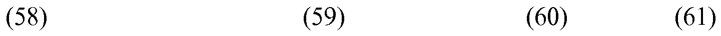 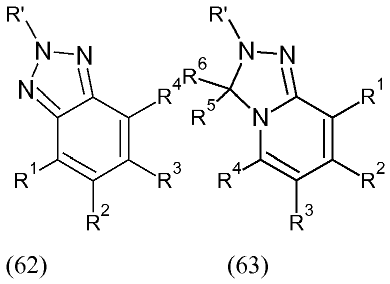 wherein:
any one of R¹, R², R³, R⁴, R⁵, R⁶, R⁷, R⁸, if applicable, may be selected, independently, from H and from hydrocarbons comprising 1 to 50 carbons and 0 to 20 heteroatoms;
R' and R" are selected, independently from substituents -CH₂R¹, -CHR¹R² and- CR¹R²R³;
with the proviso that, if the compound is a compound according to any one of formulae (1) to (5) above, at least one of said substituents R¹, R², R³, R⁴, R⁵, R⁶, R⁷, R⁸, if applicable, is selected, independently, from a substituent of formula (A-1) to (G-2) below: 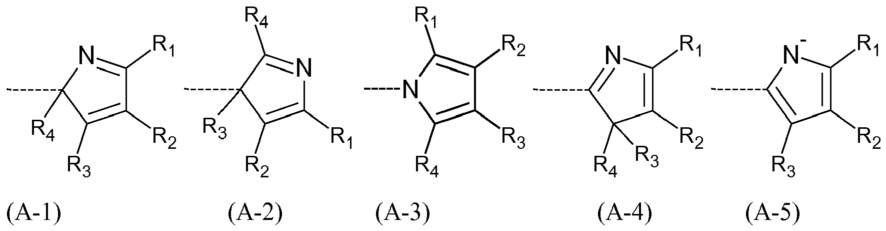 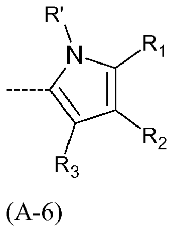 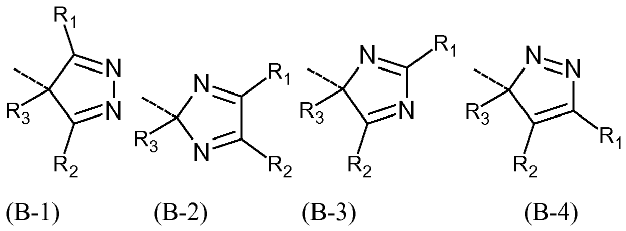 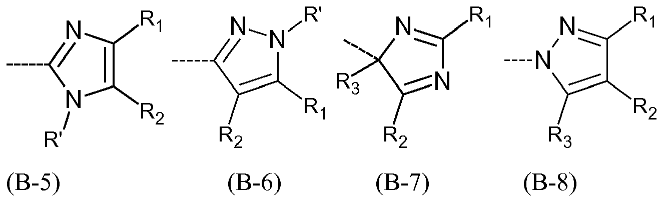 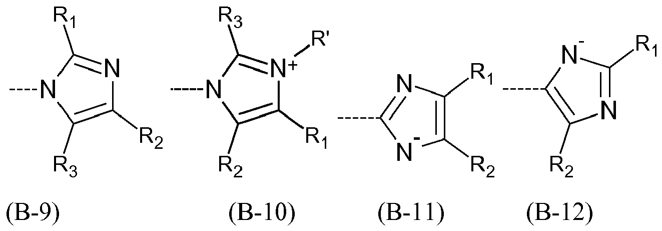 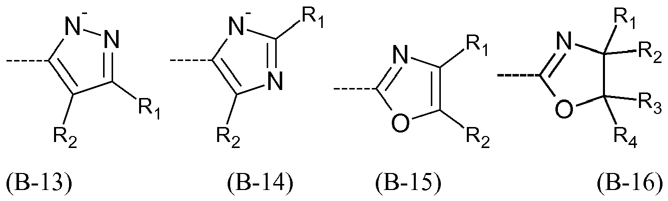 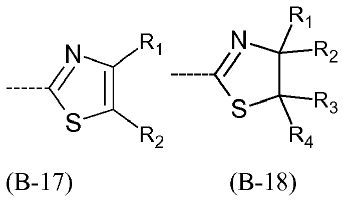 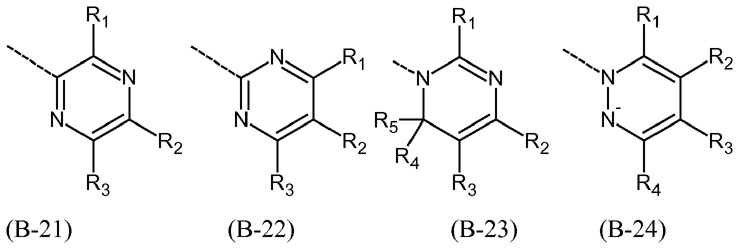 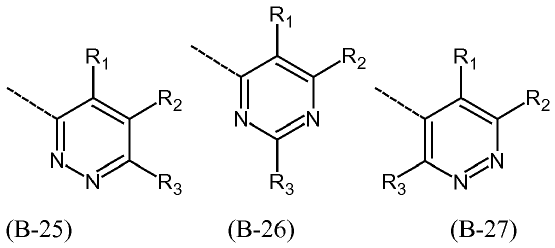 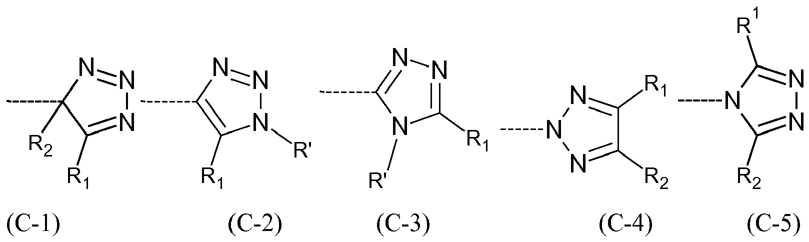 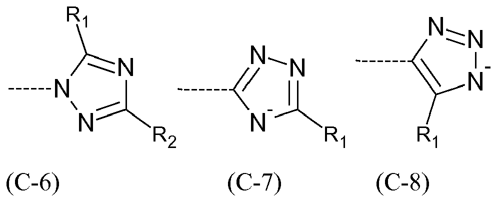 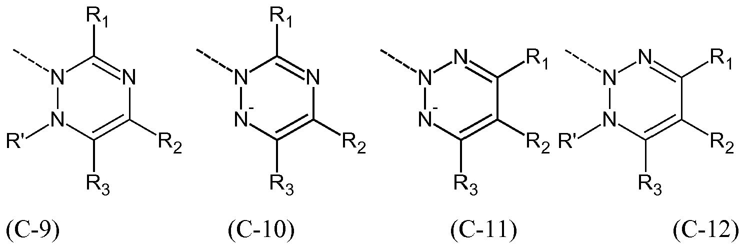 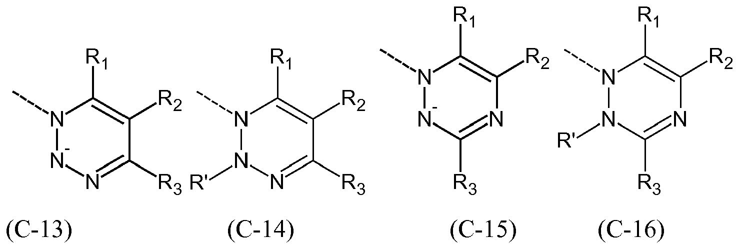 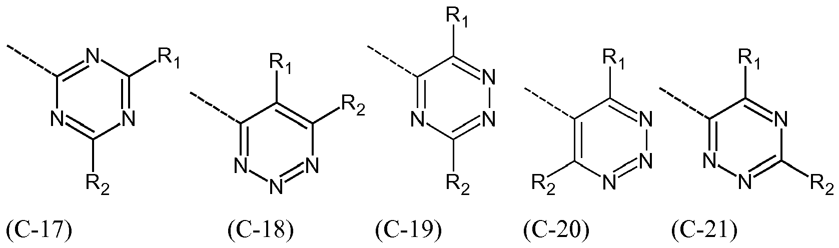 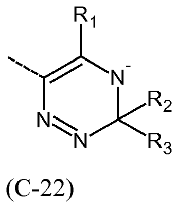 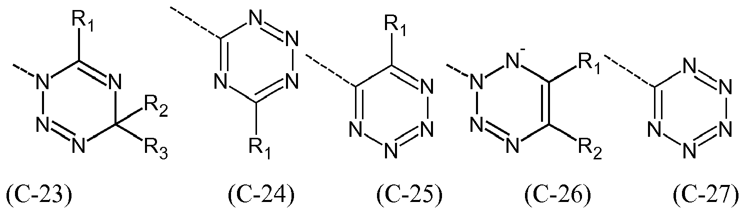 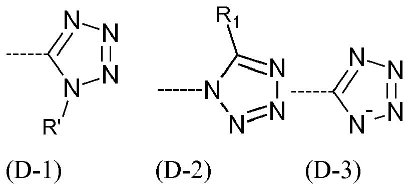 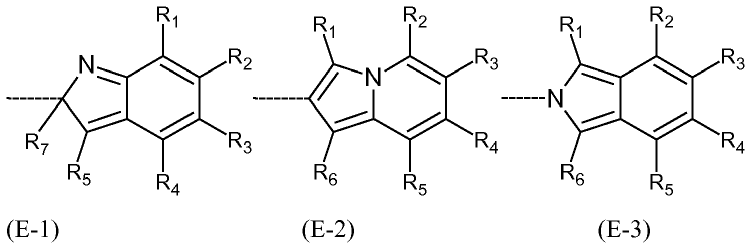 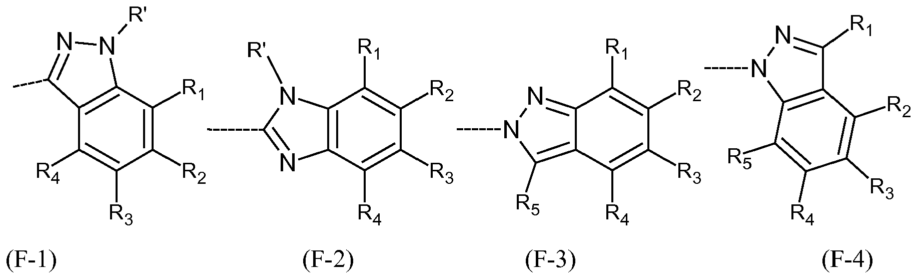 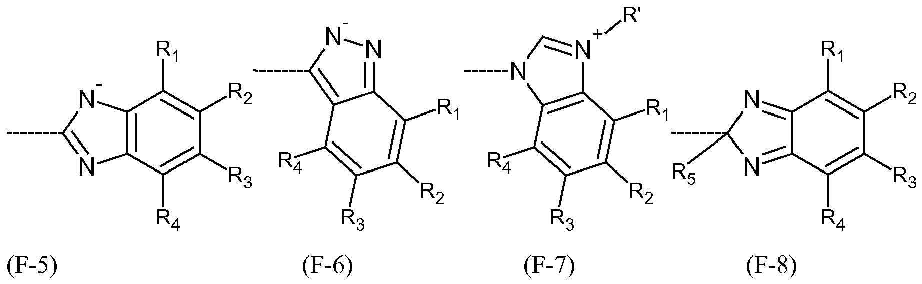 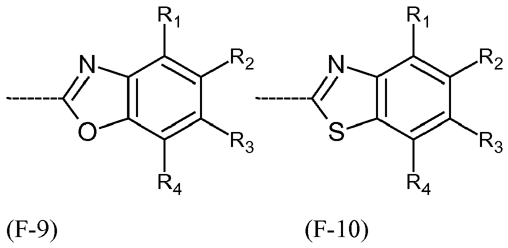 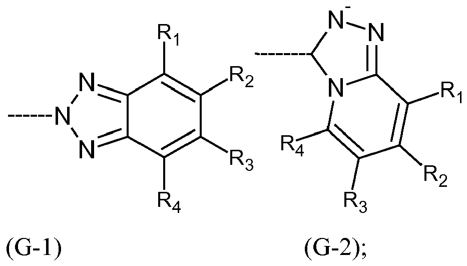 wherein:
the dotted line represents the bond connecting the substituent of (A-1) to (G-2) on the compound of formula (1)-(63); and,
substituents R₁, R₂, R₃, R₄, R₅, R₆, and R₇, in as far as present, are independently selected from H and from hydrocarbons comprising 1 to 50 carbons and 0 to 20 heteroatoms.

4. The complex of any one of the preceding claims, wherein at least one of said ligands La (L1, ... , Ln) is, independently, selected from compounds of formulae (1-2) to (3-2) below: 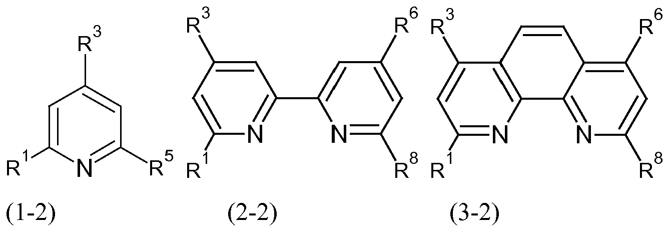 wherein:
said ligand comprises at least one substituent R¹, R³, R⁵, R⁶, R⁸ selected from the substituents (A-1) to (G-2) as defined in claim 3.

5. The complex of any one of the preceding claims, wherein at least one of said ligands La (L1, ... , Ln) is, independently, selected from compounds of formulae (1-3) to (3-3) below: 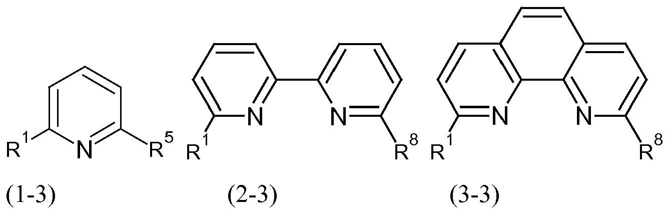 wherein, said ligand comprises at least one substituent R¹, R⁵, R⁸, as applicable, is selected from the substituents (A-1) to (G-2) as defined in claim 3.

6. The complex of any one of claims 2 to 5, wherein any one of R¹, R², R³, R⁴, R⁵, R⁶, R⁷, R⁸, R₁, R₂, R₃, R₄, R₅, R₆, R' and R", if applicable, is selected independently from H, and from C1-C10 alkyls, C2-C10 alkenyls C2-C10 alkynyls, and C5-C12 aryls (preferably C6-C12 aryls), wherein in said alkyls, alkenyls, alkynyls and aryls one, several or all available hydrogen may be replaced by halogen and/or by -CN, wherein any one of said R¹ to R⁸ and R₁ to R₆ may further be selected from halogen and from -C≡N (-CN).

7. The complex of any one of the preceding claims, wherein n is 2 (M L1 L2) or 3 (M L1, L2, L3) and m is 0.

8. The complex of any one of the preceding claims, which comprises at least 2 or at least 3 ligands La of identical structure (L1=L2 or L1=L2=L3, respectively).

9. The complex of any one of the preceding claims, which is overall neutral, or which carries an overall positive or negative charge.

10. The complex of any one of the preceding claims, wherein at least one ligand La is selected from the compounds of formula (1-5) to (3-5) below: 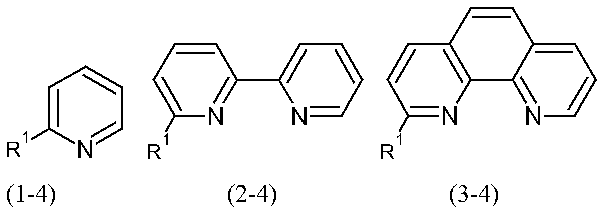 wherein:
R¹ is selected from the substituents (A-1) to (G-2) as specified in claim 3.

11. The complex of any one of the preceding claims, wherein any one of R₁, R₂, R₃, R₄, R₅, R₆ is selected from independently from H, C1-C6 linear alkyl, C3-C6 branched or cyclic alkyl, and -C≡N, wherein any one of said linear, branched or cyclic alkyl may be totally or partially halogenated, and may in particular also be-CF₃.

12. An electrochemical or optoelectronic device comprising the complex of any one of the preceding claims.

13. The device of claim 12, in which said complex and its reduced or oxidized counterpart is used as a redox-pair.

14. The device of any one of claims 12 and 13, which is selected from a photo-electrochemical device, an optoelectronic device, an electrochemical battery, (for example a lithium ion battery), a double layer capacitor, a light emitting device, an electrochromic or photo-electrochromic device, an electrochemical sensor, a biosensor, an electrochemical display and an electrochemical capacitor, (for example a super capacitor).

15. An electrochemical device comprising a first and a second electrode and, between said first and second electrode, an electrolyte and/or an intermediate layer, said electrolyte or said intermediate layer comprising a metal complex according to any one of claims 1 to 11.
